# EUROPEAN PATENT APPLICATION

(11) **EP 4 671 916 A1**
(43) Date of publication of application: **31.12.2025**
(21) Application number: 25760213.6
(22) Date of filing: 11.02.2025
(51) Int. Cl.: G06F 1/16, F16C 11/04, H05K 5/02, H04M 1/02, G09F 9/30

(54) **ROTATING SHAFT MECHANISM AND ELECTRONIC DEVICE**

(30) Priority: 08.03.2024 CN 202410263727
(71) Applicant: Honor Device Co., Ltd., Shenzhen, Guangdong 518040 (CN)
(72) Inventor: WANG, Wenhao, Shenzhen, Guangdong 518040 (CN); PENG, Gaofeng, Shenzhen, Guangdong 518040 (CN); ZHANG, Ke, Shenzhen, Guangdong 518040 (CN); HU, Li, Shenzhen, Guangdong 518040 (CN)
(74) Representative: Isarpatent
(86) International application number: PCT/CN2025/076872
(87) International publication number: WO 2025/185408

(57) **Abstract**

This application provides a rotating shaft mechanism and an electronic device, and relates to the field of electronic product technologies. In a rotating shaft mechanism, at least one of a main shaft and a connecting plate assembly is provided with a support member, so that when an electronic device switches between an unfolded state and a folded state, a flexible circuit board repeatedly contacts and separates from the support member, and the flexible circuit board is deformed at a contact part at which the flexible circuit board is in contact with the support member. The support member is configured to include a support main body and a protection portion, the protection portion is disposed on a surface of a side of the support main body that faces the flexible circuit board, the protection portion covers at least the contact part of the support member, and a surface of a side of the protection portion that faces the flexible circuit board is an insulation wear-resistant surface. In this way, the flexible circuit board is in contact with the insulation wear-resistant surface of the protection portion, so that a surface of the flexible circuit board can be prevented from being worn. In addition, the insulation wear-resistant surface of the protection portion has a good insulation effect, which can avoid a short circuit occurring on the flexible circuit board and improve reliability and a service life of the flexible circuit board.

## Description

This application claims priority to Chinese Patent Application No. 202410263727.2, filed with the China National Intellectual Property Administration on March 8, 2024 and entitled "ROTATING SHAFT MECHANISM AND ELECTRONIC DEVICE", which is incorporated herein by reference in its entirety.

### TECHNICAL FIELD

This application relates to the field of electronic product technologies, and in particular, to a rotating shaft mechanism and an electronic device.

### BACKGROUND

Foldable electronic devices, such as a foldable mobile phone or a notebook computer, are increasingly popular among consumers due to advantages such as portability and large-screen display.

Two main bodies of a foldable electronic device are connected by using a rotating shaft mechanism, and relative rotation between the two main bodies is implemented through movement of the rotating shaft mechanism, so that the foldable electronic device switches between a folded state and an unfolded state. In the foldable electronic device, a flexible circuit board passing through the rotating shaft mechanism needs to be provided, so that the two main bodies are electrically connected. When the foldable electronic device switches between the folded state and the unfolded state, the rotating shaft mechanism moves relative to the main bodies, a part of the flexible circuit board that is located in the rotating shaft mechanism also moves and is deformed accordingly, and the flexible circuit board repeatedly rubs against structural members in the rotating shaft mechanism.

However, during long-term use of the foldable electronic device, a surface layer of the flexible circuit board is easily worn by the structural members, resulting in exposure of conductive wires in the flexible circuit board. Consequently, the flexible circuit board is shorted to the structural members, causing damage to the flexible circuit board.

### SUMMARY

This application provides a rotating shaft mechanism and an electronic device. The rotating shaft mechanism is not easy to wear a flexible circuit board, and the flexible circuit board is not damaged due to a short circuit, which can improve reliability of the electronic device.

An aspect of this application provides a rotating shaft mechanism, including:
a main shaft; and
a connecting plate assembly, movably connected to two sides of the main shaft in a width direction, where
at least one of the main shaft and the connecting plate assembly includes a support member, and the support member is configured to support a flexible circuit board; and the support member has a contact part, and the contact part is configured to receive a deformation part of the flexible circuit board, where
the support member includes a support main body and a protection portion, the protection portion is connected to a surface of a side of the support main body that faces the flexible circuit board, the protection portion covers at least the contact part, and a surface of a side of the protection portion that faces the flexible circuit board is an insulation wear-resistant surface.

In the rotating shaft mechanism provided in this application, at least one of the main shaft and the connecting plate assembly is provided with the support member, and the support member is configured to support a corresponding part of the flexible circuit board. In other words, when the electronic device switches between an unfolded state and a folded state, the flexible circuit board repeatedly contacts and separates from the support member, the support member has the contact part that is in contact with the flexible circuit board, and the flexible circuit board is deformed at the contact part. The support member is configured to include the support main body and the protection portion, the support main body is a main support structure of the support member, the protection portion is disposed on the surface of the side of the support main body that faces the flexible circuit board, the protection portion covers at least the contact part of the support member, and the surface of the side of the protection portion that faces the flexible circuit board is the insulation wear-resistant surface. In this way, the flexible circuit board is in contact with the insulation wear-resistant surface of the protection portion, and a coefficient of friction of the insulation wear-resistant surface of the protection portion is small, so that a surface of the flexible circuit board can be prevented from being worn. In addition, the insulation wear-resistant surface of the protection portion has a good insulation effect, which can avoid a short circuit occurring to the flexible circuit board, improve reliability of the flexible circuit board, and prolong a service life of the electronic device.

In a possible implementation, when the flexible circuit board is in contact with the protection portion, the flexible circuit board smoothly transitions at the contact part.

When the flexible circuit board is in contact with the protection portion of the support member, the flexible circuit board smoothly transitions at the contact part at which the flexible circuit board is in contact with the protection portion. In this way, the flexible circuit board is prevented from being excessively compressed by the rotating shaft mechanism, to prevent the flexible circuit board from being cracked or broken, thereby ensuring the reliability and a service life of the flexible circuit board.

In a possible implementation, the protection portion covers the surface of the side of the support main body that faces the flexible circuit board.

The protection portion covers the surface of the side of the support main body that faces the flexible circuit board, so that a coverage area of the protection portion is large, and a mounting tolerance of the protection portion is small. Therefore, it can be ensured that the protection portion effectively covers the contact part of the support member, thereby ensuring that the flexible circuit board is in contact with the protection portion. In addition, a large contact area between the protection portion and the support main body can enhance a connection strength between the protection portion and the support main body, and improve integrity and reliability of the support member.

In a possible implementation, the protection portion includes a metal base body and an insulation lubricating coating, and the insulation lubricating coating covers at least a surface of a side of the metal base body that faces the flexible circuit board.

The metal base body is used as a main structure of the protection portion, so that a structural strength of the metal base body is high, requirements on a structural strength of the protection portion can be satisfied, and a thickness of the protection portion can be reduced. Further, a thickness of the entire support member is reduced, and a thickness of the entire rotating shaft mechanism is reduced. The surface of the side of the metal base body that faces the flexible circuit board is covered with the insulation lubricating coating, so that the surface of the side of the protection portion that faces the flexible circuit board forms the insulation wear-resistant surface. In this way, the surface of the flexible circuit board can be prevented from being worn, and a short circuit can be prevented from occurring on the flexible circuit board, thereby reducing a risk that the flexible circuit board burns out.

In a possible implementation, the insulation lubricating coating covers an outer surface of the metal base body.

The entire outer surface of the metal base body is covered with the insulation lubricating coating, so that it is convenient to spray the insulation lubricating coating on the outer surface of the metal base body. In addition, when the metal base body is of a symmetrical structure, the metal base body does not need to be positioned, thereby improving mounting efficiency and mounting accuracy of the protection portion.

In a possible implementation, the insulation lubricating coating includes one of a polyimide coating, a polytetrafluoroethylene coating, a polyphenylene sulfide coating, and a polyetheretherketone coating.

These high-polymer coatings are used as insulation lubricating coatings, and these high-polymer coatings have relatively low friction damping and are prone to plastic deformation, so that a contact area in contact with the metal base body can be enlarged and stress concentration is relieved. In addition, these high-polymer coatings have good anti-corrosion and a vibration-absorbing function, which can avoid occurrence of corrosion wear and impact wear. In addition, these high-polymer coatings have good stability and high reliability.

In a possible implementation, a thickness of a part having a smallest thickness of the metal base body is greater than or equal to 0.2 mm.

The thickness of the part having the smallest thickness of the metal base body is greater than or equal to 0.2 mm, so that the metal base body satisfies requirements on metal diecasting and forming, thereby ensuring that the metal base body can be manufactured and formed, and ensuring reliability of the metal base body.

In a possible implementation, the protection portion includes a plastic base body.

The plastic base body is used as a main structure of the protection portion, so that a coefficient of friction of the plastic base body is small and wear resistance is good. In addition, the plastic base body can implement insulation, and there is no need to perform surface spraying or other surface processing on the plastic base body, so that production costs of the protection portion can be saved. In addition, a weight of the plastic base body is small, so that a weight of the support member can be reduced.

In a possible implementation, a thickness of a part having a smallest thickness of the plastic base body is greater than or equal to 0.3 mm.

The thickness of the part having the smallest thickness of the plastic base body is greater than or equal to 0.3 mm, so that the plastic base body satisfies requirements on injection modeling, thereby ensuring that the plastic base body can be manufactured and formed, and ensuring reliability of the plastic base body.

In a possible implementation, the protection portion further includes an insulation lubricating coating, and the insulation lubricating coating covers at least a surface of a side of the plastic base body that faces the flexible circuit board.

The insulation lubricating coating is disposed on the surface of the plastic base body, so that the insulation lubricating coating covers at least the surface of the side of the plastic base body that faces the flexible circuit board, the coefficient of friction of the protection portion can be further reduced, lubrication and wear resistance of the protection portion is enhanced, and the protection portion is prevented from wearing against the flexible circuit board.

In a possible implementation, the insulation lubricating coating covers an outer surface of the plastic base body.

In a possible implementation, the insulation lubricating coating includes one of a polyimide coating, a polytetrafluoroethylene coating, a polyphenylene sulfide coating, and a polyetheretherketone coating.

Another aspect of this application provides an electronic device, including a first housing, a second housing, a foldable screen, and the foregoing rotating shaft mechanism, where the first housing and the second housing are respectively connected to two sides of the rotating shaft mechanism; and
the foldable screen includes a first non-bendable portion, a bendable portion, and a second non-bendable portion that are sequentially disposed, the first non-bendable portion and the second non-bendable portion are respectively attached to the first housing and the second housing, and the bendable portion is supported by the rotating shaft mechanism.

The electronic device provided in this application includes the first housing, the second housing, the foldable screen, and the rotating shaft mechanism. The rotating shaft mechanism is movably connected between the first housing and the second housing. The first non-bendable portion and the second non-bendable portion of the foldable screen are respectively attached to the first housing and the second housing. The bendable portion of the foldable screen is supported by the rotating shaft mechanism. In the rotating shaft mechanism, at least one of the main shaft and the connecting plate assembly is provided with the support member, and the support member is configured to support a corresponding part of the flexible circuit board. In other words, when the electronic device switches between an unfolded state and a folded state, the flexible circuit board repeatedly contacts and separates from the support member, the support member has a contact part that is in contact with the flexible circuit board, and the flexible circuit board is deformed at the contact part. The support member is configured to include the support main body and the protection portion, the support main body is a main support structure of the support member, the protection portion is disposed on the surface of the side of the support main body that faces the flexible circuit board, the protection portion covers at least the contact part of the support member, and the surface of the side of the protection portion that faces the flexible circuit board is the insulation wear-resistant surface. In this way, the flexible circuit board is in contact with the insulation wear-resistant surface of the protection portion, and a coefficient of friction of the insulation wear-resistant surface of the protection portion is small, so that a surface of the flexible circuit board can be prevented from being worn. In addition, the insulation wear-resistant surface of the protection portion has a good insulation effect, which can avoid a short circuit occurring to the flexible circuit board, improve reliability of the flexible circuit board, and prolong a service life of the electronic device.

In a possible implementation, when the electronic device is in a folded state, the first housing and the second housing are relatively stacked, and the foldable screen is located between the first housing and the second housing, where
a support member is a shaft cover of the main shaft, and a contact part is two ends of the support member in a width direction.

When the electronic device is an inward-folding electronic device, the flexible circuit board repeatedly contacts and rubs against the two ends of the shaft cover of the main shaft in the width direction. In this case, the support member may be used as the shaft cover of the main shaft, and the support main body may be used as a main support structure of the shaft cover. The protection portion covers at least the two ends of the support main body in the width direction, so that the flexible circuit board is in contact with the insulation wear-resistant surface of the protection portion. In this way, the surface of the flexible circuit board can be prevented from being worn, and a short circuit can be prevented from occurring between the flexible circuit board and the protection portion, to improve reliability of the flexible circuit board and prolong the service life of the flexible circuit board.

In a possible implementation, a right projection of the protection portion on the support main body is located in a coverage region of the support main body; and
a spacing between an edge of the protection portion and a corresponding edge of the support main body is less than or equal to an extreme bending radius of the flexible circuit board.

The right projection of the protection portion on the support main body is located in the coverage region of the support main body, to prevent the protection portion from exceeding the support main body, prevent the protection portion from interfering with a housing assembly, and prevent the protection portion from affecting an appearance effect of the shaft cover. In addition, the spacing between the edge of the protection portion and the corresponding edge of the support main body is less than or equal to the extreme bending radius of the flexible circuit board. In this way, it can be ensured that the flexible circuit board is not in contact with the support main body, the flexible circuit board is prevented from being worn by the support main body, and the flexible circuit board is prevented from being shorted to the support main body, to ensure the reliability and the service life of the flexible circuit board.

In a possible implementation, when the electronic device is in an unfolded state, a spacing between the contact part of the support member and a connecting plate assembly is a preset spacing, and a difference between the preset spacing and a thickness of the flexible circuit board is greater than or equal to 0.3 mm.

The difference between the preset spacing between the contact part of the support member and the connecting plate assembly and the thickness of the flexible circuit board is greater than or equal to 0.3 mm, so that the flexible circuit board can smoothly move and be deformed with movement of the rotating shaft mechanism, thereby preventing the flexible circuit board from being stuck and worn or broken.

In a possible implementation, when the electronic device is in a folded state, the first housing and the second housing are relatively stacked, and the foldable screen is disposed around outside of the first housing and the second housing, where
the support member includes a first support member, and the first support member is located at the connecting plate assembly.

When the electronic device is an outward-folding electronic device, the flexible circuit board repeatedly contacts and rubs against the connecting plate assembly. In this case, the first support member is disposed as a structural member that is in the connecting plate assembly and that repeatedly contacts and rubs against the flexible circuit board, so that during long-term use of the electronic device, the flexible circuit board is in contact with the insulation wear-resistant surface of the protection portion in the first support member. In this way, the surface of the flexible circuit board can be prevented from being worn, and a short circuit can be prevented from occurring between the flexible circuit board and the protection portion, to improve reliability of the flexible circuit board and prolong the service life of the flexible circuit board.

In a possible implementation, the connecting plate assembly includes an inner connecting plate and an outer connecting plate that are sequentially connected to a side of the main shaft, the first support member is the inner connecting plate, and the contact part is far away from a first end of the inner connecting plate and close to a second end of the inner connecting plate, where
the first end of the inner connecting plate is an end of the inner connecting plate that is close to the main shaft, and the second end of the inner connecting plate is an end of the inner connecting plate that is far away from the main shaft.

The inner connecting plate and the outer connecting plate are sequentially connected on the side of the main shaft, so that a large planar work piece occupied by the connecting plate assembly can stably support the bendable portion. In addition, the inner connecting plate and the outer connecting plate may move relative to each other, so that a posture of the connecting plate assembly is more flexible, and a bending requirement of the bendable portion can be satisfied. In this case, a part on the inner connecting plate that is far away from the first end of the inner connecting plate and close to the second end of the inner connecting plate repeatedly contacts and rubs against the flexible circuit board. The part is the contact part of the inner connecting plate. Therefore, the first support member is used as the inner connecting plate, so that the protection portion covers at least the contact part of the inner connecting plate, and the flexible circuit board is in contact with the insulation wear-resistant surface of the protection portion. In this way, the surface of the flexible circuit board can be prevented from being worn, and a short circuit can be prevented from occurring between the flexible circuit board and the protection portion, to improve reliability of the flexible circuit board and prolong the service life of the flexible circuit board.

In a possible implementation, the rotating shaft mechanism further includes a decorative plate, the decorative plate is movably connected to the two sides of the main shaft in the width direction, and the decorative plate is located on a side of the main shaft that faces away from the foldable screen.

In a possible implementation, the support member further includes a second support member, the second support member is the decorative plate, and the contact part is close to a first end of the decorative plate and far away from a second end of the decorative plate, where
the first end of the decorative plate is an end of the decorative plate that is close to the main shaft, and the second end of the decorative plate is an end of the decorative plate that is far away from the main shaft.

When the electronic device is an outward-folding electronic device, the flexible circuit board may also repeatedly contact and rub against the decorative plate. A part on the decorative plate that is close to the first end of the decorative plate and far away from the second end of the decorative plate repeatedly contacts and rubs against the flexible circuit board. The part is the contact part of the decorative plate. Therefore, the second support member is used as the decorative plate, so that the protection portion covers at least the contact part of the decorative plate, and the flexible circuit board is in contact with the insulation wear-resistant surface of the protection portion. In this way, the surface of the flexible circuit board can be prevented from being worn, and a short circuit can be prevented from occurring between the flexible circuit board and the protection portion, to improve reliability of the flexible circuit board and prolong the service life of the flexible circuit board.

### BRIEF DESCRIPTION OF DRAWINGS

FIG. 1 is a schematic structural diagram of an electronic device in an unfolded state according to an embodiment of this application;
FIG. 2 is a schematic structural diagram of the electronic device shown in FIG. 1 in a folded state;
FIG. 3 is a schematic structural diagram of the electronic device in FIG. 1 in a semi-unfolded state;
FIG. 4 is a schematic diagram of an exploded structure of an electronic device according to an embodiment of this application;
FIG. 5 is a schematic diagram of an internal structure of an electronic device;
FIG. 6 is a cross-sectional view of the electronic device in FIG. 5 along a line A-A;
FIG. 7 is a schematic diagram of movement of an electronic device;
FIG. 8 is a schematic diagram showing that a flexible circuit board burns out due to a short circuit at a rotating shaft mechanism;
FIG. 9 is a schematic diagram of an internal structure of another electronic device;
FIG. 10 is a partial cross-sectional view of the electronic device in FIG. 9 along a line B-B;
FIG. 11 is a partial structural diagram of a third type of electronic device in an unfolded state;
FIG. 12 is a partial structural diagram of the electronic device in FIG. 11 in a folded state;
FIG. 13 is a partial structural diagram of an electronic device in an unfolded state according to an embodiment of this application;
FIG. 14 is a partial structural diagram of the electronic device in FIG. 13 in a folded state;
FIG. 15 is a partial enlarged structural diagram of a position A in FIG. 13;
FIG. 16 is a partial structural diagram of another electronic device in an unfolded state according to an embodiment of this application; and
FIG. 17 is a partial structural diagram of the electronic device in FIG. 16 in a folded state.

### Descriptions of referential numerals:

10-Electronic device;
100-Display screen; 100a-Foldable screen; 100b-Flat screen; 200-Housing assembly; 300-Flexible circuit board;
100-First non-bendable portion; 102-Bendable portion; 103-Second non-bendable portion; 210-First housing; 220-Second housing; 230-Rotating shaft mechanism;
201-Middle frame; 202-Rear cover; 211-First circuit board; 212-First battery; 221-Second circuit board; 222-Second battery; 231-Main shaft; 232: Connecting plate assembly; 233-Decorative plate; 234-Support member;
2311-Shaft cover; 2312-Support base; 2313-Base plate; 2314-Cover plate; 2321-Connecting plate; 2322-Inner connecting plate; 2323-Outer connecting plate; 2341-Support main body; 2342-Protection portion;
a-Contact point; and b-Contact part.

### DESCRIPTION OF EMBODIMENTS

Terms used in the implementation parts of this application are merely used for explaining specific embodiments of this application, but are not intended to limit this application.

Embodiments of this application provide an electronic device. The electronic device may be a foldable electronic device. In addition, the electronic device may be a consumer electronic product. For example, the electronic device includes, but is not limited to, a foldable electronic product such as a foldable mobile phone, a laptop computer (laptop computer), a notebook computer, a netbook, a personal digital assistant (personal digital assistant, PDA), a personal computer, a multimedia player, an ebook reader, an in-vehicle device, a virtual reality (virtual reality, VR) device, an augmented reality (augmented reality, AR) device, or a wearable device. The wearable device includes, but is not limited to, a smart band, a smart watch, a smart head-mounted display, smart glasses, and the like.

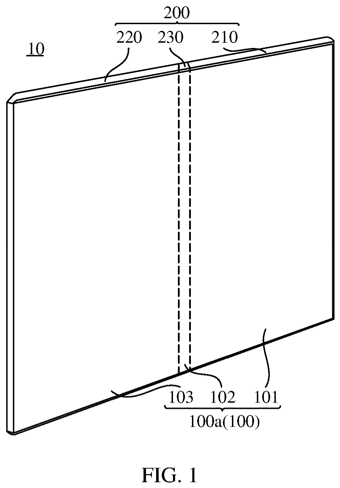

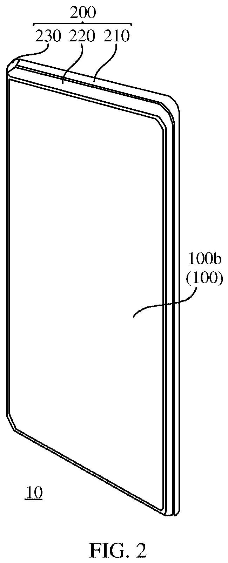

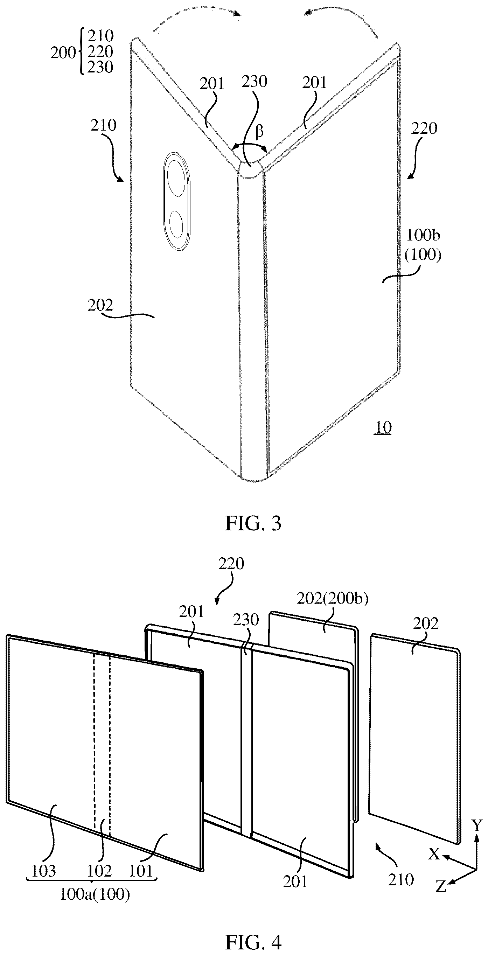

FIG. 1 is a schematic structural diagram of an electronic device in an unfolded state according to an embodiment of this application. FIG. 2 is a schematic structural diagram of the electronic device shown in FIG. 1 in a folded state. FIG. 3 is a schematic structural diagram of the electronic device in FIG. 1 in a semi-unfolded state.

Refer to FIG. 1 to FIG. 3. This embodiment is described by using an example in which an electronic device 10 is a foldable mobile phone.

For the electronic device 10, the electronic device 10 may have different use states in different use scenarios. FIG. 1 shows the electronic device 10 in the unfolded state. An unfolding angle α of the electronic device 10 is, for example, 180°. In this case, the electronic device 10 can implement large-screen display. FIG. 2 shows the electronic device 10 in the folded state. In this case, the electronic device 10 has a relatively small volume and is convenient to carry. FIG. 3 shows the electronic device 10 in the semi-unfolded state. In this case, the electronic device 10 is suspended at an angle between the unfolded state and the folded state. For example, a suspension angle β of the electronic device 10 may be 120°, 130°, 140°, 150°, or the like.

It should be noted that some deviations are allowed in all the angles described by using examples in this embodiment. For example, that the unfolding angle α of the electronic device 10 shown in FIG. 1 is 180° means that the unfolding angle α may be 180°, or may be approximately 180°, for example, 170°, 175°, 185°, or 190°. Angles described by using examples below can be understood in the same manner.

In addition, the electronic device 10 shown in FIG. 1 to FIG. 3 is an electronic device 10 that can be folded once, and the electronic device 10 includes two parts that can rotate with each other. When the two parts are rotated to be coplanar, the electronic device 10 is in the unfolded state (as shown in FIG. 1); when the two parts are rotated to be stacked on each other, the electronic device 10 is in the folded state (as shown in FIG. 2); and when the two parts are rotated to an angle suspended between the unfolded state and the folded state, the electronic device 10 is in the semi-unfolded state (as shown in FIG. 3).

In another implementation, the electronic device 10 may alternatively be an electronic device that can be folded more than twice. In this case, the electronic device 10 may include a plurality of parts that are rotatably connected in sequence. Two adjacent parts may move away relative to each other to be unfolded to the unfolded state, and the two adjacent parts may alternatively move close relative to each other to be folded to the folded state.

FIG. 4 is a schematic diagram of an exploded structure of an electronic device according to an embodiment of this application. Refer to FIG. 4. The electronic device 10 includes a display screen 100 and a housing assembly 200. A surface of a side of the display screen 100 is used for displaying image information. Generally, the surface of the side of the display screen 100 is defined as a front surface of the display screen 100, and a surface of the other side opposite to the front surface of the display screen 100 is defined as a rear surface of the display screen 100. The housing assembly 200 is disposed around a peripheral side and the rear surface of the display screen 100, and is configured to support and fix the display screen 100 and protect the display screen 100. The front surface of the display screen 100 is exposed outside the housing assembly 200, for a user to view content displayed on the display screen 100 or perform an input operation on the electronic device 10.

The display screen 100 of the electronic device 10 may include a foldable screen 100a. The foldable screen 100a may include a first non-bendable portion 101, a bendable portion 102, and a second non-bendable portion 103 that are sequentially disposed in a first direction, or in other words, the bendable portion 102 is located between the first non-bendable portion 101 and the second non-bendable portion 103 in the first direction. A folding manner of the electronic device 10 may be transverse-folding shown in FIG. 1 to FIG. 3. In this case, the first direction may be an X direction shown in FIG. 4. Definitely, the folding manner of the electronic device 10 may alternatively be vertical-folding. This is not limited in this embodiment.

For example, the foldable screen 100a may be made of a flexible material, so that the bendable portion 102 is bendable. The foldable screen 100a may be an organic light-emitting diode (organic light-emitting diode, OLED) display screen.

The housing assembly 200 is configured to support and fix the foldable screen 100a, and drive the foldable screen 100a to switch between the folded state and the unfolded state. Refer to FIG. 4. The housing assembly 200 includes a first housing 210, a second housing 220, and a rotating shaft mechanism 230. The rotating shaft mechanism 230 is connected between the first housing 210 and the second housing 220. The first housing 210 and the second housing 220 are rotatably connected by using the rotating shaft mechanism 230, so that the first housing 210 and the second housing 220 rotate relative to each other.

The first housing 210 supports and fixes the first non-bendable portion 101 of the foldable screen 100a, and the second housing 220 supports and fixes the second non-bendable portion 103 of the foldable screen 100a. In other words, the first non-bendable portion 101 of the foldable screen 100a is fixedly connected to the first housing 210, the second non-bendable portion 103 of the foldable screen 100a is fixedly connected to the second housing 220, and the bendable portion 102 of the foldable screen 100a is disposed corresponding to the rotating shaft mechanism 230.

During use of the electronic device 10, the first non-bendable portion 101 and the second non-bendable portion 103 of the foldable screen 100a always remain in a planar state, and the bendable portion 102 of the foldable screen 100a may be bent. When the rotating shaft mechanism 230 drives the first housing 210 and the second housing 220 to rotate relative to each other, the first non-bendable portion 101 and the second non-bendable portion 103 of the foldable screen 100a accordingly change orientations, and the bendable portion 102 of the foldable screen 100a bends or flattens as the orientations of the first non-bendable portion 101 and the second non-bendable portion 103 change.

The first housing 210 and the second housing 220 may rotate in a direction away from each other until the first housing 210 and the second housing 220 are coplanar. In this case, the housing assembly 200 is in the unfolded state, and the foldable screen 100a is in the unfolded state as the housing assembly 200 is unfolded, as shown in FIG. 1. The first housing 210 and the second housing 220 may alternatively rotate in a direction approaching each other until the first housing 210 and the second housing 220 are relatively stacked. In this case, the housing assembly 200 is in the folded state, and the foldable screen 100a is in the folded state as the housing assembly 200 is folded, as shown in FIG. 2. It should be noted that this embodiment uses an example in which the electronic device 10 is an inward-folding electronic device. When the electronic device 10 is in the folded state, the first non-bendable portion 101 and the second non-bendable portion 103 of the foldable screen 100a are relatively attached to each other, the housing assembly 200 is disposed around outside the foldable screen 100a, and the foldable screen 100a is located between the first housing 210 and the second housing 220. In this way, when the inward-folding electronic device is in the folded state, the housing assembly 200 may provide protection to the foldable screen 100a, to prevent the foldable screen 100a from being scuffed by a hard object.

Refer to FIG. 2 or FIG. 3. If the inward-folding electronic device needs to implement a display function in the folded state, a flat screen 100b may be added at a rear surface of a housing, and in the folded state, the electronic device 10 implements the display function relying on the flat screen 100b. In other words, the inward-folding electronic device may include the foldable screen 100a and the flat screen 100b. The foldable screen 100a may be mounted on a front surface of the housing assembly 200. With movement of the housing assembly 200, the foldable screen 100a can switch between the unfolded state and the folded state. When the electronic device 10 is in the folded state, the foldable screen 100a is invisible to the outside. The flat screen 100b may be mounted on the rear surface of the housing assembly 200, and the flat screen 100b performs display when the electronic device 10 is in the folded state.

In another example, the electronic device 10 may alternatively be an outward-folding electronic device. When the electronic device 10 is in the folded state, the first non-bendable portion 101 and the second non-bendable portion 103 of the foldable screen 100a face away from each other, and the housing assembly 200 is located between the first non-bendable portion 101 and the second non-bendable portion 103. In other words, when the outward-folding electronic device is in the folded state, the foldable screen 100a is disposed around outside of the first housing 210 and the second housing 220. The foldable screen 100a is visible to a user, and the display function can be implemented by using the foldable screen 100a. Therefore, to implement the display function of the electronic device 10 in the folded state, the flat screen 100b does not need to be additionally added on the rear surface of the housing.

In addition, in some implementations, the electronic device 10, especially the inward-folding electronic device, can be suspended at an angle between the unfolded state and the folded state. For example, a suspension angle of the electronic device 10 may be 120°, 130°, 140°, 150°, or the like. The housing assembly 200 can be suspended in the semi-unfolded state between the folded state and the unfolded state relying on a damping force provided by the housing assembly 200, and the foldable screen 100a stays in the semi-unfolded state with the housing assembly 200. In this case, the bendable portion 102 of the foldable screen 100a is also in a bent state, and a bending degree of the bendable portion 102 is less than a bending degree of the bendable portion 102 in the folded state. The first non-bendable portion 101 and the second non-bendable portion 103 of the foldable screen 100a are inclined relative to each other, and an angle between the first non-bendable portion 101 and the second non-bendable portion 103 is, for example, 120°, 130°, 140°, 150°, or the like.

Still refer to FIG. 4. In the housing assembly 200 of the foldable electronic device, both the first housing 210 and the second housing 220 may include a middle frame 201, and the first non-bendable portion 101 and the second non-bendable portion 103 of the foldable screen 100a may be supported on a front surface of the corresponding middle frame 201. For the outward-folding electronic device or an inward-folding electronic device in which the flat screen 100b is not additionally disposed, both the first housing 210 and the second housing 220 of the electronic device 1 may further include a rear cover 202. The rear cover 202 is connected to a surface of a side of the middle frame 201 that faces away from the foldable screen 100a. For an inward-folding electronic device in which the flat screen 100b is additionally disposed, one of the first housing 210 and the second housing 220 may not include the rear cover 202, and instead, the flat screen 100b is mounted on a rear surface of the middle frame 201.

In the first housing 210 and the second housing 220, the middle frame 201 and the rear cover 202 (or the flat screen 100b) jointly enclose an accommodating cavity. The accommodating cavity is configured to mount some functional components (not shown in the figure) of the electronic device 10. For example, the accommodating cavity is configured to mount components such as a circuit board, a battery, a camera module, a microphone, and a speaker.

As described above, the electronic device 10 may include the inward-folding electronic device and the outward-folding electronic device. The inward-folding electronic device may include a transverse-folding electronic device and a vertical-folding electronic device. To be specific, the transverse-folding electronic device 10 is unfolded or transversely folded, and the vertical-folding electronic device 10 is unfolded or folded vertically.

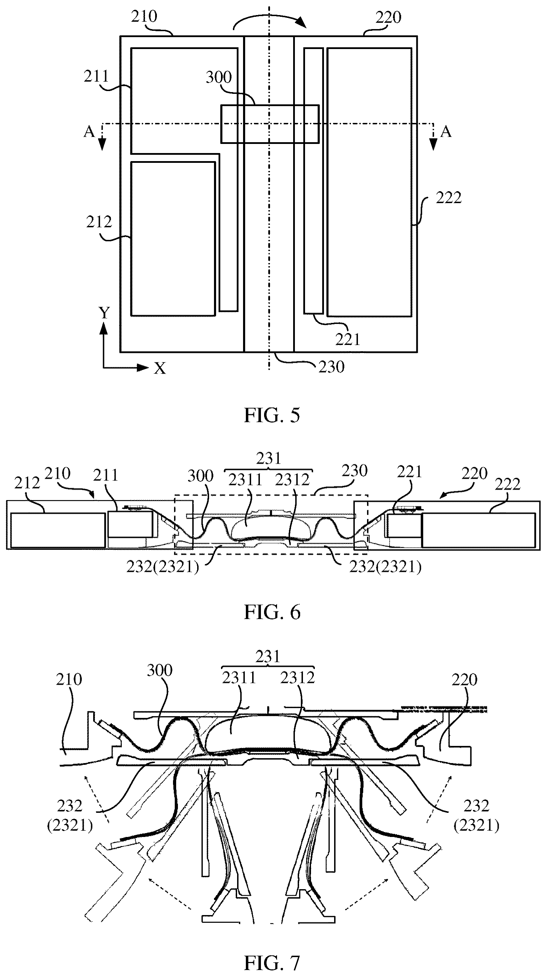

FIG. 5 is a schematic diagram of an internal structure of an electronic device. FIG. 6 is a cross-sectional view of the electronic device in FIG. 5 along a line A-A. Refer to FIG. 5 or FIG. 6. In the figure, an example in which the electronic device 10 is the inward-folding electronic device is used. Specifically, an example in which the electronic device 10 is the transverse-folding electronic device is used. The electronic device 10 transversely rotates in a direction of an arrow shown in FIG. 5, so that the electronic device 10 is unfolded or folded.

Refer to FIG. 5 or FIG. 6. In the transverse-folding electronic device 10, the first housing 210, the rotating shaft mechanism 230, and the second housing 220 are sequentially disposed in an X direction shown in FIG. 5. Both the first housing 210 and the second housing 220 may be provided with a circuit board. The circuit board disposed in the first housing 210 may include a first circuit board 211. The first circuit board 211 is, for example, a most important circuit board in the electronic device 10. The first circuit board 211 may be provided with components such as a system-on-a-chip (System-on-a-chip, SOC), a memory, a radio frequency component, and a power supply chip. The circuit board disposed in the second housing 220 may include a second circuit board 221. The second circuit board 221, for example, may be provided with components such as a radio frequency device and a power chip, and a component that cannot be integrated into the first circuit board 211 may be integrated on the second circuit board 221.

Both the first housing 210 and the second housing 220 may be provided with a battery. For example, the first housing 210 is provided with a first battery 212, and the second housing 220 is provided with a second battery 222. The two batteries are disposed, so that a total capacity of a battery disposed in the housing assembly 200 is improved, and it is ensured that requirements of the electronic device 10 can be satisfied. In addition, the two batteries are respectively disposed in the first housing 210 and the second housing 220, so that weights of the first housing 210 and the second housing 220 are more balanced, thereby improving use experience of the electronic device 10.

Other components such as the camera module, the microphone, and the speaker may be integrally disposed in the first housing 210 or the second housing 220, or some components are disposed in the first housing 210, and some components are disposed in the second housing 220.

Still refer to FIG. 5 or FIG. 6. Because there is relative movement between the first housing 210 and the second housing 220, to implement an electrical connection between the first housing 210 and the second housing 220, a flexible circuit board 300 passing through the rotating shaft mechanism 230 usually needs to be disposed, to connect a component in the first housing 210 to a component in the second housing 220. For example, one end of the flexible circuit board 300 is connected to the first circuit board 211 in the first housing 210, and the other end of the flexible circuit board 300 is connected to the second circuit board 221 in the second housing 220. All other components in the first housing 210 are electrically connected to the first circuit board 211, and all other components in the second housing 220 are electrically connected to the second circuit board 221, so that the components are electrically connected.

The flexible printed circuit (Flexible Printed Circuit, FPC for short) 300 is a printed circuit with high reliability and excellent flexibility that is made by using polyimide or a polyester film as a base material. The flexible circuit board 300 has advantages such as a high wiring density, a light weight, a thin thickness, and good bendability, and is suitable for connecting the component in the first housing 210 to the component in the second housing 220 by passing through the rotating shaft mechanism 230. The flexible circuit board 300 passing through the rotating shaft mechanism 230 may be referred to as a through-shaft FPC.

Refer to FIG. 6. The rotating shaft mechanism 230 may include a main shaft 231 and connecting plate assemblies 232. The main shaft 231 extends in an extending direction (a Y direction shown in FIG. 5) of side edges of the first housing 210 and the second housing 220 that are opposite to each other. The connecting plate assemblies 232 are movably connected to two sides of the main shaft 231. The connecting plate assemblies 232 on the two sides of the main shaft 231 are respectively connected to the first housing 210 and the second housing 220. For example, the connecting plate assemblies 232 on the two sides of the main shaft 231 are respectively connected to the middle frame 201 of the first housing 210 and the middle frame 201 of the second housing 220. The connecting plate assemblies 232 on the two sides of the main shaft 231 move relative to the main shaft 231, to drive the first housing 210 and the second housing 220 to move relative to each other, so that the electronic device 10 switches between the unfolded state and the folded state.

The main shaft 231 is used as a main support structure of the rotating shaft mechanism 230, and is equivalent to a rotating shaft of the first housing 210 and the second housing 220. The first housing 210 and the second housing 220 rotate relative to the main shaft 231. The first housing 210 and the second housing 220 are connected to the two sides of the main shaft 231 by using the connecting plate assemblies 232. The connecting plate assemblies 232 move relative to the main shaft 231, so that a rotating shaft structure switches between the unfolded state and the folded state, thereby driving the electronic device 10 to be unfolded and folded.

During movement of the rotating shaft mechanism 230, it may be considered that the main shaft 231 is stationary, and a part of the flexible circuit board 300 corresponding to the main shaft 231 may be fixedly connected to the main shaft 231. In a process of the electronic device 10 switching between the unfolded state and the folded state, the flexible circuit board 300 moves with movement of the electronic device 10, and the flexible circuit board 300 is deformed. For example, the flexible circuit board 300 changes between the bent state and the unfolded state.

During long-term use of the electronic device 10, the flexible circuit board 300 repeatedly contacts a (or some) structural member(s) of the rotating shaft mechanism 230, and repeatedly rubs against a contact position. To ensure a structural strength of the rotating shaft mechanism 230, many structural members in the rotating shaft mechanism 230 are made of a metal material. When a structural member that the flexible circuit board 300 contacts and rubs against is a metal member, because a surface of the structural member made of the metal material is relatively rough, the flexible circuit board 300 repeatedly contacts and rubs against the structural member in a long term, which easily causes the flexible circuit board 300 to be scuffed and worn.

After a surface layer (for example, a polyimides layer) of the flexible circuit board 300 is worn out, a metal wire (for example, a copper wire) in the flexible circuit board 300 is exposed and is in contact with the structural member, and a short circuit may occur to the structural member made of the metal material. However, a large current (for example, a current for charging a battery) needs to pass through the flexible circuit board 300, and if the short circuit occurs on the flexible circuit board 300, there is a risk that the flexible circuit board 300 burns out.

FIG. 7 is a schematic diagram of movement of an electronic device. Refer to FIG. 7. FIG. 7 shows a partial structure of a part of the electronic device 10 at which the rotating shaft mechanism 230 is located, and shows states in which the electronic device 10 moves to different positions. The electronic device 10 may gradually switch from the folded state to the unfolded state in a manner shown by an arrow in the figure.

In FIG. 7, an example in which the electronic device 10 is the inward-folding electronic device is used. Specifically, an example in which the electronic device 10 is the transverse-folding electronic device 10 is used. The main shaft 231 of the rotating shaft mechanism 230 may include a shaft cover 2311 and a support base 2312. The shaft cover 2311 is located on a side of the rotating shaft mechanism 230 that faces away from the foldable screen 100a. For example, the shaft cover 2311 may be disposed close to the rear cover 202 of the housing assembly 200. The support base 2312 is disposed on a side of the shaft cover 2311 that is close to the foldable screen 100a. The support base 2312 may be adhered to the shaft cover 2311 or may be integrally formed on the shaft cover 2311 by using an injection process. Alternatively, the support base 2312 may be locked to the shaft cover 2311 by using a locking member such as a screw or a rivet.

Using the connecting plate assembly 232 on one side of the main shaft 231 as an example, the connecting plate assembly 232 may include at least one connecting plate 2321, the connecting plate 2321 is movably connected to the main shaft 231, and the connecting plate 2321, for example, may be movably connected to the support base 2312. For example, the connecting plate assembly 232 includes one connecting plate 2321, and two ends of the connecting plate 2321 in a length direction (the Y direction in FIG. 5) may extend to the two ends of the main shaft 231 in a length direction. Alternatively, the connecting plate assembly 232 may include a plurality of connecting plates 2321, and the plurality of connecting plates 2321 may be disposed at intervals in the length direction of the main shaft 231.

When the electronic device 10 is in the unfolded state, the housing assembly 200 may be shielded outside the shaft cover 2311. For example, the rear cover 202 of the first housing 210 and the rear cover 202 of the second housing 220 are separately shielded at two sides of the shaft cover 2311. When the electronic device 10 is in the folded state, the first housing 210 and the second housing 220 move relative to each other until the first housing 210 and the second housing 220 are stacked on each other. The housing assembly 200 is located on a side of the shaft cover 2311, and a surface of a side of the shaft cover 2311 that faces away from the foldable screen 100a is exposed outside the housing assembly 200, and forms a part of an appearance surface of the electronic device 10. In view of this, the shaft cover 2311 is usually made of a metal material. In other words, the shaft cover 2311 is a metal member, so that the shaft cover 2311 keeps a consistent texture and a consistent color with the housing assembly 200, and it is ensured that the main shaft 231 has a sufficient structural strength, thereby ensuring to satisfy requirements on stability and reliability of the electronic device 10.

When the flexible circuit board 300 is applied to the inward-folding electronic device, the flexible circuit board 300 may be disposed between the shaft cover 2311 and the support base 2312. Alternatively, a part of the flexible circuit board 300 that passes through the main shaft 231 is located between the shaft cover 2311 and the support base 2312. For example, the flexible circuit board 300 is clipped between the shaft cover 2311 and the support base 2312, and the part of the flexible circuit board 300 that passes through the main shaft 231 may further be fixed through adhesion, magnetic adsorption, or the like.

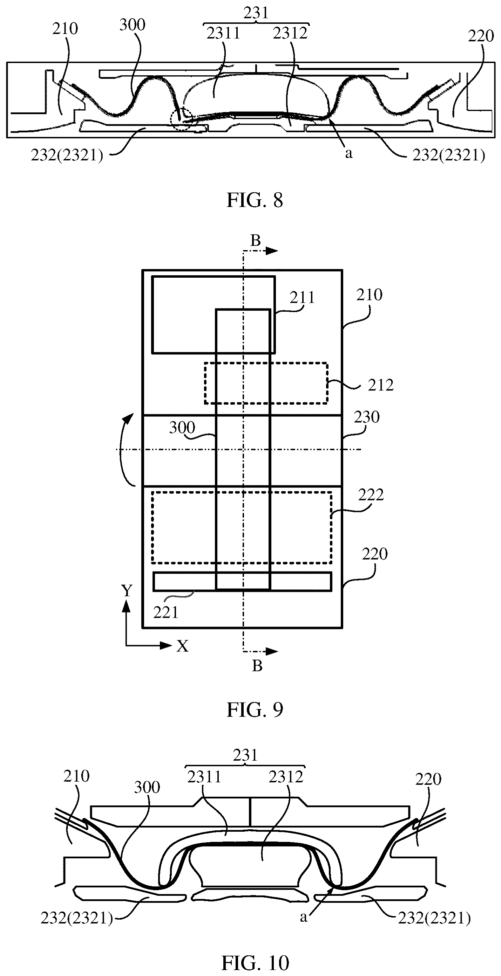

Still refer to FIG. 7. Because the flexible circuit board 300 is fixed between the shaft cover 2311 and the support base 2312, in a process of the electronic device 10 switching between the unfolded state and the folded state, the part of the flexible circuit board 300 between the shaft cover 2311 and the support base 2312 is not deformed, and mainly, the flexible circuit board 300 repeatedly contacts and separates from parts of two ends of the shaft cover 2311 in a width direction. Therefore, refer to FIG. 8. FIG. 8 shows a case in which the flexible circuit board 300 burns out due to a short circuit at the rotating shaft mechanism 230. Because a surface of the shaft cover 2311 made of the metal material is relatively rough, and edges of the shaft cover 2311 usually have edges and processing glitches, the flexible circuit board 300 repeatedly contacts and rubs against the two ends of the shaft cover 2311 in a long term, which easily causes a surface layer of the flexible circuit board 300 at a contact point a (which is in contact with the two ends of the shaft cover 2311) to be worn, and exposes the metal wire in the flexible circuit board 300. Further, the flexible circuit board 300 is shorted to the shaft cover 2311 made of the metal material at the contact position a, and burns out (which is shown in the figure by using a dashed line).

FIG. 9 is a schematic diagram of an internal structure of another electronic device. FIG. 10 is a partial cross-sectional view of the electronic device in FIG. 9 along a line B-B. Refer to FIG. 9 or FIG. 10. In the figure, an example in which the electronic device 10 is the inward-folding electronic device is used. Specifically, an example in which the electronic device 10 is the vertical-folding electronic device 10 is used. The electronic device 10 vertically rotates in a direction of an arrow shown in FIG. 9, so that the electronic device 10 is unfolded or folded.

Refer to FIG. 9 or FIG. 10. Different from the transverse-folding electronic device 10, in the vertical-folding electronic device 10, the first housing 210, the rotating shaft mechanism 230, and the second housing 220 are sequentially disposed in a Y direction shown in FIG. 9.

Similar to the transverse-folding electronic device 10, in the vertical-folding electronic device 10, both the first housing 210 and the second housing 220 may be provided with a circuit board. The circuit board disposed in the first housing 210 may include a first circuit board 211, and the first circuit board 211 is, for example, a most important circuit board in the electronic device 10. The circuit board disposed in the second housing 220 may include a second circuit board 221, and a component that cannot be integrated into the first circuit board 211 may be integrated on the second circuit board 221. Both the first housing 210 and the second housing 220 may be provided with a battery. For example, the first housing 210 is provided with a first battery 212, and the second housing 220 is provided with a second battery 222. Other components such as the camera module, the microphone, and the speaker may be integrally disposed in the first housing 210 or the second housing 220, or some components are disposed in the first housing 210, and some components are disposed in the second housing 220.

The flexible circuit board 300 is connected to the components in the first housing 210 and the components in the second housing 220 by passing through the rotating shaft mechanism 230. For example, one end of the flexible circuit board 300 is connected to the first circuit board 211 in the first housing 210, and the other end of the flexible circuit board 300 is connected to the second circuit board 221 in the second housing 220. Details are not described herein.

Refer to FIG. 10. The rotating shaft mechanism 230 may include the main shaft 231 and the connecting plate assemblies 232. The main shaft 231 extends in an extending direction (an X direction shown in FIG. 9) of the side edges of the first housing 210 and the second housing 220 that are opposite to each other. The connecting plate assemblies 232 are movably connected to the two sides of the main shaft 231. The connecting plate assemblies 232 on the two sides of the main shaft 231 are respectively connected to the first housing 210 and the second housing 220. For example, the connecting plate assemblies 232 on the two sides of the main shaft 231 are respectively connected to the middle frame 201 of the first housing 210 and the middle frame 201 of the second housing 220. In addition, the main shaft 231 of the rotating shaft mechanism 230 may include the shaft cover 2311 and the support base 2312, the connecting plate assembly 232 may include at least one connecting plate 2321 disposed in an extending direction of the main shaft 231, and the flexible circuit board 300 may be disposed between the shaft cover 2311 and the support base 2312. Details are not described herein.

Compared with the transverse-folding electronic device 10, the vertical-folding electronic device 10 has a lower requirement on a thickness, as long as the electronic device 10 has a suitable thickness in the unfolded state. Therefore, the first housing 210 and the second housing 220 may have a relatively large thickness, and the rotating shaft mechanism 230 may also have a relatively large thickness. The main shaft 231 of the rotating shaft mechanism 230 may have a relatively large thickness. For example, the main shaft 231 may be designed as a hollow structure similar to a shape of an inverted bowl.

Similar to the transverse-folding electronic device 10, in the vertical-folding electronic device 10, the flexible circuit board 300 repeatedly contacts and rubs against the two ends of the shaft cover 2311 in a long term, which easily causes the surface layer of the flexible circuit board 300 at the contact point a (which is in contact with the two ends of the shaft cover 2311) to be worn, and exposes the metal wire in the flexible circuit board 300. Further, the flexible circuit board 300 is shorted to the shaft cover 2311 made of the metal material at the contact position a, and burns out.

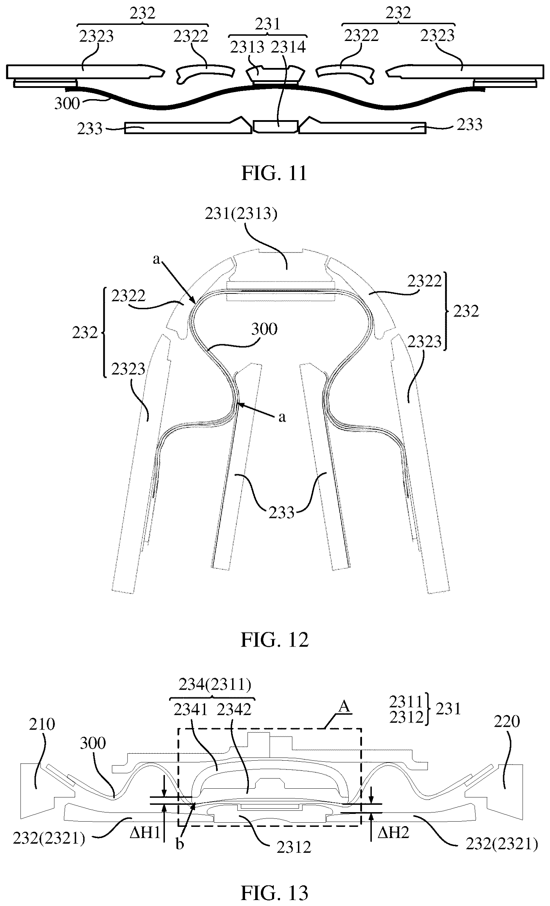

FIG. 11 is a partial structural diagram of a third type of electronic device in an unfolded state. FIG. 12 is a partial structural diagram of the electronic device in FIG. 11 in a folded state. Refer to FIG. 11 and FIG. 12. FIG. 11 and FIG. 12 show a partial structure of a part of the electronic device 10 at which the rotating shaft mechanism 230 is located, and the electronic device 10 shown in the FIG. 11 and FIG. 12 is the outward-folding electronic device.

Refer to FIG. 11 or FIG. 12. When the electronic device 10 is the outward-folding electronic device, the main shaft 231 of the rotating shaft mechanism 230 may include a base plate 2313, and the base plate 2313 is located on a side of the rotating shaft mechanism 230 that faces the foldable screen 100a. For example, the main shaft 231 may support the bendable portion of the foldable screen 100a relying on the base plate 2313. Refer to FIG. 11. The main shaft 231 may further include a cover plate 2314. The cover plate 2314 may be located on a side of the main shaft 231 that faces away from the foldable screen 100a. The cover plate 2314 may be used as an appearance member of the rotating shaft mechanism 230. When the electronic device 10 is in the unfolded state, the cover plate 2314 is exposed to the outside and forms a part of the appearance surface of the electronic device 10. The connecting plate assembly 232 of the rotating shaft mechanism 230 may be connected to a middle part of the main shaft 231 in a thickness direction (a Z direction shown in FIG. 4). For example, the connecting plate assembly 232 is connected between the base plate 2313 and the cover plate 2314.

In view of this, the base plate 2313 of the main shaft 231 may be made of a metal material. In other words, the base plate 2313 is a metal member, to ensure that the base plate 2313 has a sufficient structural strength, ensure that the base plate 2313 stably supports the bendable portion of the foldable screen 100a, and satisfy requirements on stability and reliability of the electronic device 10. The cover plate 2314 of the main shaft 231 may also be made of a metal material. In other words, the cover plate 2314 is a metal member, so that the cover plate 2314 keeps a consistent texture and a consistent color with the housing assembly 200, and it is ensured that the cover plate 2314 has a sufficient structural strength.

Still refer to FIG. 11 or FIG. 12. For the outward-folding electronic device, when the electronic device 10 is in the folded state, the bendable portion of the foldable screen 100a is disposed around an outer side of the rotating shaft mechanism 230, and a bending radius of the bendable portion of the foldable screen 100a is larger. Therefore, a width (a size in the X direction shown in FIG. 4) of the bendable portion is also larger. Correspondingly, a width (a size in the X direction shown in FIG. 4) of the rotating shaft mechanism 230 supporting the bendable portion is usually also larger, and a deformation space required by the rotating shaft mechanism 230 in the width direction of the rotating shaft mechanism 230 is usually also larger, to satisfy bending requirements of the bendable portion and ensure that the rotating shaft mechanism 230 stably supports the bendable portion.

In view of this, in the outward-folding electronic device, the connecting plate assembly 232 of the rotating shaft mechanism 230 may include an inner connecting plate 2322 and an outer connecting plate 2323, and the inner connecting plate 2322 and the outer connecting plate 2323 are sequentially connected to a side of the main shaft 231. In other words, the inner connecting plate 2322 is located between the main shaft 231 and the outer connecting plate 2323. Both the inner connecting plate 2322 and the outer connecting plate 2323 may move relative to the main shaft 231, and the outer connecting plate 2323 may move relative to the inner connecting plate 2322, so that the rotating shaft mechanism 230 switches between the unfolded state and the folded state. The rotating shaft mechanism 230 may be respectively connected to the first housing 210 and the second housing 220 by using the outer connecting plates 2323 on the two sides. For example, the first housing 210 and the second housing 220 are respectively mechanically connected to the corresponding outer connecting plate 2323 by using a locking member such as a screw or a river, so that the first housing 210 and the second housing 220 are driven to move relative to each other by using the outer connecting plates 2323 on the two sides.

The inner connecting plate 2322 and the outer connecting plate 2323 are provided to jointly support the bendable portion of the foldable screen 100a. In this way, the inner connecting plate 2322 and the outer connecting plate 2323 occupy a larger plane space, so that the size of the rotating shaft mechanism 230 in the width direction of the rotating shaft mechanism 230 can be enlarged, and the connecting plate assembly 232 can stably support the bendable portion, to ensure a planarity of the bendable portion in a flattened state and enable the bendable portion to smoothly transition to a bent state. In addition, in a process of the rotating shaft mechanism 230 switching between the unfolded state and the folded state, the inner connecting plate 2322 and the outer connecting plate 2323 sequentially and continuously change postures, so that a posture of the connecting plate assembly 232 is more flexible, and a requirement of a large bending radius of the bendable portion is satisfied. Especially in the folded state, the bendable portion can be stably supported, and a smoothness of the bendable portion in the bent state can be improved.

For the outward-folding electronic device, the rotating shaft mechanism 230 may further include decorative plates 233 and the decorative plates 233 are also movably connected to the two sides of the main shaft 231 in the width direction. In addition, the decorative plates 233 may be connected to the side of the main shaft 231 that faces away from the foldable screen 100a. For example, the decorative plates 233 are connected to two sides of the cover plate 2314. The decorative plates 233 may be movably connected to the main shaft 231 only. For example, the decorative plates 233 are connected to the cover plate 2314 by using a hinge or a rotating shaft, to avoid hindering movement of the housing assembly 200 driven by the rotating shaft mechanism 230. The decorative plates 233 mainly play a function of covering an internal structure of the rotating shaft mechanism 230, and cover a gap between the main shaft 231 and the housing assembly 200, to improve an appearance effect of the electronic device 10.

For example, to improve a structural strength of the rotating shaft mechanism 230 and ensure movement reliability of the rotating shaft mechanism 230, both the inner connecting plate 2322 and the outer connecting plate 2323 may be made of a metal material. In other words, both the inner connecting plate 2322 and the outer connecting plate 2323 are metal plates. Similarly, the decorative plates 233 may also be made of a metal material. In other words, the decorative plates 233 are metal plates.

With reference to FIG. 11 and FIG. 12, when a flexible circuit board 300 is applied to the outward-folding electronic device, the flexible circuit board 300 may be disposed between the base plate 2313 and the cover plate 2314, and the flexible circuit board 300 is usually fixedly connected to the base plate 2313. For example, the flexible circuit board 300 is clipped between the base plate 2313 and the cover plate 2314, and the part of the flexible circuit board 300 that passes through the main shaft 231 may further be fixed through adhesion, magnetic adsorption, or the like.

Because the flexible circuit board 300 is fixed to the main shaft 231, in a process of the electronic device 10 switching between the unfolded state and the folded state, the part of the flexible circuit board 300 between the base and the cover plate 2314 is not deformed, and mainly, the flexible circuit board 300 repeatedly contacts and separates from the connecting plate assembly 232. When the flexible circuit board 300 is deformed, parts of the flexible circuit board 300 that are located on the two sides of the main shaft 231 constantly bend and unfold. Therefore, the flexible circuit board 300 usually repeatedly contacts and separates from the inner connecting plate 2322. In addition, a part of the flexible circuit board 300 between the inner connecting plate 2322 and the outer connecting plate 2323 also continuously bends and unfolds. Because the part of the flexible circuit board 300 bends toward the decorative plate 233, the flexible circuit board 300 may further repeatedly contact and separate from the decorative plate 233.

For ease of description, in this embodiment, an end of the inner connecting plate 2322 that is close to the main shaft 231 is defined as a first end of the inner connecting plate 2322, and an end of the inner connecting plate that is away from the main shaft 231 is defined as a second end of the inner connecting plate 2322. Similarly, an end of the decorative plate 233 that is close to the main shaft 231 is defined as a first end of the decorative plate 233, and an end of the decorative plate 233 that is far away from the main shaft 231 is defined as a second end of the decorative plate 233. With reference to FIG. 11 and FIG. 12, in a process of the electronic device 10 switching between the unfolded state and the folded state, a part on the inner connecting plate 2322 that repeatedly contacts and separates from the flexible circuit board 300 is generally far away from the first end of the inner connecting plate 2322 and close to the second end of the inner connecting plate 2322. A part on the decorative plate 233 that repeatedly contacts and separates from the flexible circuit board 300 is usually close to the first end of the decorative plate 233 and far away from the second end of the decorative plate 233.

Similar to the inward-folding electronic device, in the outward-folding electronic device, in a process of the flexible circuit board 300 repeatedly contacting and rubbing against the inner connecting plate 2322 and the decorative plate 233 in a long term, the surface layer of the flexible circuit board 300 at the contact point a (that is in contact with the inner connecting plate 2322 and the decorative plate 233) is easily worn, and the metal wire inside the flexible circuit board 300 is exposed. When the inner connecting plate 2322 and the decorative plate 233 are metal plates, the flexible circuit board 300 is shorted to the inner connecting plate 2322 and the decorative plate 233 at the contact point a and burns out.

To prevent the flexible circuit board 300 from being worn, in the related technology, some solutions are to attach a Mylar film to a part on the surface of the flexible circuit board 300 that is in contact with a structural member, to improve wear resistance of the part of the flexible circuit board 300. However, such a solution may make the flexible circuit board 300 partially thicker, resulting in a decrease in a bending performance of the flexible circuit board 300 and a decrease in reliability of the flexible circuit board 300. In addition, mechanical properties such as tensile modulus of the attached Mylar film are greatly different from those of the flexible circuit board 300 provided with the metal wire, and deformation does not match when the flexible circuit board 300 is bent, which reduces a bending life of the flexible circuit board 300. Especially as the foldable electronic device 10 is becoming thinner and lighter, a bending space and a bending angle of the flexible circuit board 300 in a positive electrode are very small, and a manner of thickening the flexible circuit board 300 can no longer meet requirements on bending life.

In some other solutions, the Mylar film is adhered to a part on a surface of the structural member that is in contact with the flexible circuit board 300, to achieve lubrication, wear prevention, and insulation, thereby protecting the flexible circuit board 300. However, such a solution has many use limitations. For example, if the Mylar film is adhered to a curved surface, the Mylar film is prone to falling off and warping. In this way, the Mylar film cannot provide effective protection, and the flexible circuit board 300 may still be worn and short-circuited. In addition, using the inward-folding electronic device as an example, an edge of a shaft cover 2311 is an appearance surface (a contact position for use by a user), and the Mylar film cannot be adhered to this part. Consequently, a protection function of the Mylar film is limited. In addition, there is usually a fitting tolerance when the Mylar film is actually attached, a transition surface of the shaft cover 2311 cannot be effectively protected, and the flexible circuit board 300 is still worn and short-circuited.

In view of this, this embodiment improves the rotating shaft mechanism 230 of the electronic device 10. At least one of the main shaft 231 and the connecting plate assembly 232 is provided with a support member, and the support member is configured to support a corresponding part of the flexible circuit board 300. In other words, when the electronic device 10 switches between the unfolded state and the folded state, the flexible circuit board 300 repeatedly contacts and separates from the support member, the support member has a contact part that is in contact with the flexible circuit board 300, and the flexible circuit board 300 is deformed at the contact part. The support member is configured to include a support main body and a protection portion, the support main body is a main support structure of the support member, the protection portion is disposed on a surface of a side of the support main body that faces the flexible circuit board 300, the protection portion covers at least the contact part of the support member, and the surface of the side of the protection portion that faces the flexible circuit board 300 is an insulation wear-resistant surface. In this way, the flexible circuit board 300 is in contact with the insulation wear-resistant surface of the protection portion, and a coefficient of friction of the insulation wear-resistant surface of the protection portion is small, so that the surface of the flexible circuit board 300 can be prevented from being worn. In addition, the insulation wear-resistant surface of the protection portion has a good insulation effect, which can avoid a short circuit occurring to the flexible circuit board 300, improve the reliability of the flexible circuit board 300, and prolong a service life of the electronic device 10.

The following describes the rotating shaft mechanism 230 of the electronic device 10 provided in this embodiment in detail.

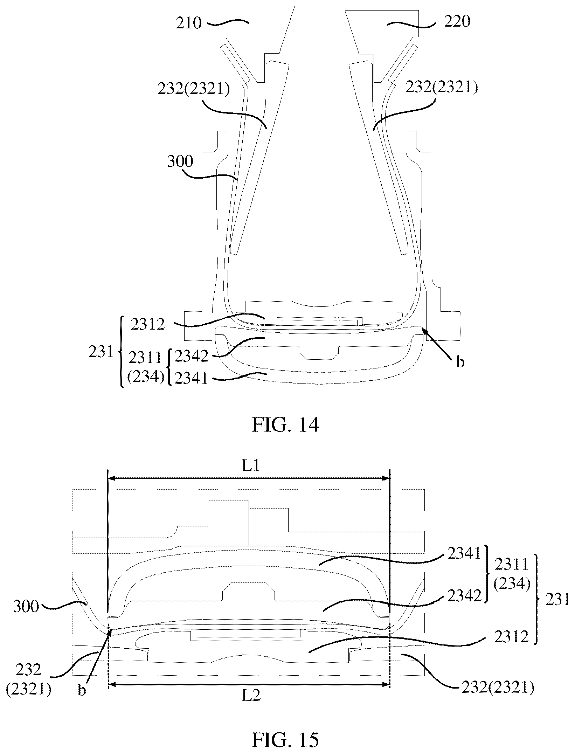

FIG. 13 is a partial structural diagram of an electronic device in an unfolded state according to an embodiment of this application. FIG. 14 is a partial structural diagram of the electronic device in FIG. 13 in a folded state.

Refer to FIG. 13 and FIG. 14. FIG. 13 and FIG. 14 show a partial structure of a part of the electronic device 10 in this embodiment at which the rotating shaft mechanism 230 is located. Refer to FIG. 13. FIG. 13 shows the rotating shaft mechanism 230 when the electronic device 10 is in the unfolded state. Refer to FIG. 14. FIG. 14 shows the rotating shaft mechanism 230 when the electronic device 10 is in the folded state.

In this embodiment, the rotating shaft mechanism 230 includes a support member 234. In other words, the support member 234 is disposed in the rotating shaft mechanism 230. The support member 234 is configured to support a corresponding part of the flexible circuit board 300. In other words, a part of the flexible circuit board 300 corresponding to the support member 234 may be supported on the support member 234. When the electronic device 10 switches between the unfolded state and the folded state, the flexible circuit board 300 moves accordingly and is deformed, and a local region of the flexible circuit board 300 repeatedly contacts the support member 234. In other words, the flexible circuit board 300 repeatedly changes between a state in which the flexible circuit board contacts the support member 234 and a state in which the flexible circuit board separates from the support member 234.

For ease of description, a contact part b of the support member 234 is defined in this embodiment. The contact part b of the support member 234 is a part repeatedly contacting the flexible circuit board 300. During long-term use of the electronic device 10, the flexible circuit board 300 repeatedly contacts and rubs against the contact part b of the support member 234. When the flexible circuit board 300 contacts the contact part b of the support member 234, the contact part b of the support member 234 generates pressure on the flexible circuit board 300, and the flexible circuit board 300 is usually deformed. In other words, the contact part b of the support member 234 may be configured to receive a deformation part of the flexible circuit board 300.

For a contact state between another part of the support member 234 and the flexible circuit board 300, based on different types of the electronic device 10 (the electronic device 10 is the inward-folding electronic device or the outward-folding electronic device) and different parts (the support member 234 is located on the main shaft 231 or the connecting plate assembly 232) at which the support member 234 is located, the contact state between the another part of the support member 234 and the flexible circuit board 300 may also be different. For example, when the electronic device 10 is the inward-folding electronic device, and the support member 234 is the shaft cover 2311 of the main shaft 231, the another part of the support member 234 may be always in contact with the flexible circuit board 300. When the electronic device 10 is the outward-folding electronic device, and the support member 234 is the inner connecting plate 2322 of the connecting plate assembly 232, the another part of the support member 234 may not be always in contact with the flexible circuit board 300. When the electronic device 10 is the outward-folding electronic device, and the support member 234 is the base plate 2313 of the main shaft 231, the another part of the support member 234 may be always in contact with the flexible circuit board 300.

Because the flexible circuit board 300 repeatedly contacts and rubs against the contact part b of the support member 234, the flexible circuit board 300 may also be deformed at the contact part b of the support member 234. To prevent the flexible circuit board 300 from being worn by the contact part b of the support member 234, and prevent the flexible circuit board 300 from being shorted to the support member 234, refer to FIG. 13 or FIG. 14. In this embodiment, the support member 234 may include a support main body 2341 and a protection portion 2342. The protection portion 2342 is connected to a surface of a side of the support main body 2341 that faces the flexible circuit board 300. In addition, the protection portion 2342 covers at least the contact part b of the support member 234. A surface of a side of the protection portion 2342 that faces the flexible circuit board 300 is an insulation wear-resistant surface.

In the support member 234, a support main body 2341 may be a metal member, to ensure an overall structural strength of the support member 234, thereby ensuring a structural strength and motion stability of the rotating shaft mechanism 230, and ensuring reliability and the service life of the electronic device 10. The protection portion 2342 is disposed on the surface of the side of the support main body 2341 that faces the flexible circuit board 300, the protection portion 2342 covers at least the contact part b of the support member 234, and the surface of the side of the protection portion 2342 that faces the flexible circuit board 300 is used as the insulation wear-resistant surface, so that the flexible circuit board 300 is in contact with the insulation wear-resistant surface of the protection portion 2342. For example, the protection portion 2342 may be connected to the support main body 2341 through soldering or adhesion, or the protection portion 2342 may be locked to the support main body 2341 by using a locking member such as a screw or a rivet.

In this configuration, the flexible circuit board 300 is in contact with the protection portion 2342 only, and the flexible circuit board 300 is in contact with only the insulation wear-resistant surface of the protection portion 2342. In this way, a coefficient of friction of the insulation wear-resistant surface of the protection portion 2342 is small and wear resistance is good, so that the surface of the flexible circuit board 300 can be prevented from being worn. During long-term use of the electronic device 10, integrity of the flexible circuit board 300 can be protected, the reliability of the flexible circuit board 300 can be improved, and a service life of the flexible circuit board 300 can be prolonged. Further, the reliability of the electronic device 10 is improved, and the service life of the electronic device 10 is prolonged.

In addition, the insulation wear-resistant surface of the protection portion 2342 has a good insulation effect and good insulation, so that the support member 234 can be in insulation contact with the flexible circuit board 300. During long-term use of the electronic device 10, even if the surface layer of the flexible circuit board 300 is worn, and the wire inside the flexible circuit board 300 is exposed, the flexible circuit board 300 can also be prevented from being shorted to the protection portion 2342, and the flexible circuit board 300 can be prevented from being shorted. In this way, a risk that the flexible circuit board 300 burns out can be reduced, the reliability of the flexible circuit board 300 can be improved, and the service life of the flexible circuit board 300 can be prolonged. Further, the reliability of the electronic device 10 is improved, and the service life of the electronic device 10 is prolonged.

Refer to FIG. 13 or FIG. 14. When the flexible circuit board 300 is applied to the inward-folding electronic device, the support member 234 in the rotating shaft mechanism 230 may be the shaft cover 2311 of the main shaft 231. In other words, the shaft cover 2311 may include the support main body 2341 and the protection portion 2342. The support main body 2341 is a main support structure of the shaft cover 2311, and the protection portion 2342 is disposed on the surface of the side of the support main body 2341 that faces the flexible circuit board 300. As described above, parts on the shaft cover 2311 that repeatedly contact the flexible circuit board 300 are parts of the two ends of the shaft cover 2311 in the width direction. In other words, the contact part b of the support member 234 is parts of two ends of the support member 234 in the width direction. In this case, the protection portion 2342 may cover at least the parts of the two ends of the support member 234 in the width direction.

The support member 234 is used as the shaft cover 2311, so that the flexible circuit board 300 can be prevented from being worn in a process of repeatedly contacting and rubbing against the contact part b of the shaft cover 2311, thereby preventing the flexible circuit board 300 from being shorted to the shaft cover 2311. This can improve the reliability of the flexible circuit board 300, and prolong the service life of the flexible circuit board 300. Details are not described herein again.

When the support member 234 is used as the shaft cover 2311 of the main shaft 231, the support main body 2341 may be located on a side of the support member 234 that is close to (the rear cover 202 of) the housing assembly 200, and the protection portion 2342 is connected to a side of the support main body 2341 that faces the foldable screen 100a. For example, the support main body 2341 may be of a thin plate-shaped structure, and there may be a gap between the protection portion 2342 and the support main body 2341. In this way, a weight of the shaft cover 2311 is relatively small, so that a weight of a rotating shaft structure can be reduced, thereby helping reduce a weight of the entire electronic device 10, and implementing lightweight of the electronic device 10.

When the electronic device 10 is in the folded state, a surface of a side of the support main body 2341 that faces away from the protection portion 2342 is exposed to the outside, and the surface of the side of the support main body 2341 forms a part of the appearance surface of the electronic device 10. Therefore, the support main body 2341 is usually a metal member, to satisfy requirements on a structural strength and reliability of the main shaft 231, and make the support main body 2341 keep a consistent appearance and a consistent texture with the first housing 210 and the second housing 220. In this case, surface processing usually needs to be performed on the surface of the side of the support main body 2341, to satisfy appearance requirements of the electronic device 10. Because the support main body 2341 is used as a part of the shaft cover 2311, the support main body 2341 generally has a relatively small size. When surface processing is performed on the support main body 2341, surface processing may be performed on an entire outer surface of the support main body 2341. For example, the support main body 2341 on which surface processing is performed has a smooth surface and high precision, and a surface color may be consistent with those of the first housing 210 and the second housing 220.

When the flexible circuit board 300 is applied to the outward-folding electronic device, the support member 234 in the rotating shaft mechanism 230 may include a first support member, and the first support member may be located in the connecting plate assembly 232. As described above, the inner connecting plate 2322 in the connecting plate assembly 232 repeatedly contacts the flexible circuit board 300. In other words, the first support member may be the inner connecting plate 2322, and the inner connecting plate 2322 may include the support main body 2341 and the protection portion 2342. Using an example in which a part on the inner connecting plate 2322 that repeatedly contacts the flexible circuit board 300 is away from the first end of the inner connecting plate 2322 and is close to the second end of the inner connecting plate 2322, the contact part b of the inner connecting plate 2322 is the part on the inner connecting plate 2322 that is away from the first end of the inner connecting plate 2322 and is close to the second end of the inner connecting plate 2322. In other words, the contact part b of the first support member is a part on the first support member that is away from the first end of the first support member and is close to the second end of the first support member, and the protection portion 2342 covers at least the contact part b of the first support member.

The first support member is used as the inner connecting plate 2322, so that the flexible circuit board 300 is prevented from being worn in a process of repeatedly contacting and rubbing against the contact part b of the inner connecting plate 2322, thereby preventing the flexible circuit board 300 from being shorted to the inner connecting plate 2322. This can improve the reliability of the flexible circuit board 300, and prolong the service life of the flexible circuit board 300. Details are not described herein again.

In addition, the support member 234 in the rotating shaft mechanism 230 may further include a second support member, and the second support member may be the foregoing decorative plate 233. In other words, the decorative plate 233 may also include the support main body 2341 and the protection portion 2342. Using an example in which a part on the decorative plate 233 that repeatedly contacts the flexible circuit board 300 is close to the first end of the decorative plate 233 and is away from the second end of the decorative plate 233, the contact part b of the decorative plate 233 is the part on the decorative plate 233 that is close to the first end of the decorative plate 233 and is away from the second end of the decorative plate 233. In other words, the contact part b of the second support member is a part on the second support member that is close to the first end of the second support member and is away from the second end of the second support member, and the protection portion 2342 covers at least the contact part b of the second support member.

The second support member is used as the decorative plate 233, so that the flexible circuit board 300 is prevented from being worn in a process of repeatedly contacting and rubbing against the contact part b of the decorative plate 233, thereby preventing the flexible circuit board 300 from being shorted to the decorative plate 233. This can improve the reliability of the flexible circuit board 300, and prolong the service life of the flexible circuit board 300. Details are not described herein again.

When the support member 234 is designed, the protection portion 2342 may entirely cover the surface of the side of the support main body 2341 that faces the flexible circuit board 300. In other words, the protection portion 2342 may be designed according to a shape and a size of the surface of the side of the support main body 2341, so that the protection portion 2342 completely covers the surface of the side of the support main body 2341. In this way, a covered area of the protection portion 2342 is large, and a mounting tolerance of mounting the protection portion 2342 on the surface of the support main body 2341 has a relatively small impact on position accuracy of the protection portion 2342. This can ensure that the protection portion 2342 can effectively cover the contact part b of the support member 234, ensure that the flexible circuit board 300 is in contact with the protection portion 2342, and ensure that the protection portion 2342 can play an effective function. In addition, a contact area between the protection portion 2342 and the support main body 2341 is large, especially when the protection portion 2342 is connected through soldering or adhesion, a connection area between the protection portion 2342 and the support main body 2341 can be enlarged, a connection strength between the protection portion 2342 and the support main body 2341 is enhanced, and integrity and reliability of the support member 234 are improved.

It should be noted that, that the protection portion 2342 completely covers the surface of the side of the support main body 2341 that faces the flexible circuit board 300 herein does not mean that edges of two sides of the protection portion 2342 in the width direction are to extend beyond edges of two sides of the support main body 2341 in the width direction, or the edges of the two sides of the protection portion 2342 in the width direction are to be flush with the edges of the two sides of the support main body 2341 in the width direction. Instead, the protection portion 2342 substantially covers the surface of the side of the support main body 2341. There may be a fine spacing between the edges of the two sides of the protection portion 2342 in the width direction and the edges of the two sides of the support main body 2341 in the width direction, as long as it is ensured that the protection portion 2342 can completely cover the contact part b of the support member 234, and it can be ensured that the flexible circuit board 300 is in contact with the protection portion 2342 without contacting the support main body 2341.

In addition, when a size relationship between the protection portion 2342 and the support main body 2341 is designed, when it is ensured that the flexible circuit board 300 does not contact the support main body 2341, it should further be ensured that the flexible circuit board 300 smoothly transitions when in contact with the contact part b of the support member 234. In other words, when the flexible circuit board 300 is in contact with the protection portion 2342, the flexible circuit board 300 is to smoothly transition at the contact point a (which is in contact with the contact part b of the protection portion 2342) of the flexible circuit board 300, and a phenomenon of excessive bending (dead folding) is to not occur. In this way, the flexible circuit board 300 can be prevented from being excessively compressed by the rotating shaft mechanism 230, to prevent the flexible circuit board 300 from being cracked or broken, thereby ensuring reliability and the service life of the flexible circuit board 300.

Especially when the flexible circuit board 300 is applied to the inward-folding electronic device, the flexible circuit board 300 is in contact with the two ends of the shaft cover 2311 in the width direction, and excessive bending of the flexible circuit board 300 is easy to occur. In this case, the size relationship between the protection portion 2342 and the support main body 2341 is properly designed by using the support member 234 as the shaft cover 2311, and when the flexible circuit board 300 is in contact with the contact parts b at the two ends of the shaft cover 2311 in the width direction, a phenomenon of excessively bending the flexible circuit board 300 is avoided, to ensure that the flexible circuit board 300 smoothly transitions at this part.

It should be noted that, the connecting plate assembly 232 (for example, the inner connecting plate 2322 and the outer connecting plate 2323) and the decorative plate 233 in the rotating shaft mechanism 230 are generally relatively thin, and compared with the main shaft 231, the inner connecting plate 2322, the outer connecting plate 2323, and the decorative plate 233 have relatively good flatness. Therefore, when the flexible circuit board 300 is applied to the outward-folding electronic device, the Mylar film can be attached to the surface of the inner connecting plate 2322 that faces the flexible circuit board 300, and the Mylar film at least covers the contact part b of the inner connecting plate 2322, to prevent the flexible circuit board 300 from being worn by the inner connecting plate 2322 and avoid a short circuit between the flexible circuit board 300 and the inner connecting plate 2322. Similarly, the Mylar film may be attached to the surface of the decorative plate 233 that faces the flexible circuit board 300, and the Mylar film may at least cover the contact part b of the decorative plate 233, to prevent the flexible circuit board 300 from being worn by the decorative plate 233 and avoid a short circuit between the flexible circuit board 300 and the decorative plate 233.

A structure of the support member 234 is described in detail below by using an example in which the flexible circuit board 300 is applied to the inward-folding electronic device.

In an implementation, the protection portion 2342 may use a metal material as a main structure. In this case, the protection portion 2342 may include a metal base body and an insulation lubricating coating, and the insulation lubricating coating may cover at least a surface of a side of the metal base body that faces the flexible circuit board 300. The flexible circuit board 300 is in contact with the insulation lubricating coating on a surface of the protection portion 2342.

The metal base body is used as a main structure of the protection portion 2342, so that a structural strength of the metal base body is high. This helps to reduce a thickness of the protection portion 2342 while ensuring that the protection portion 2342 meets requirements on the structural strength. Further, a thickness of the entire support member 234 can be reduced, thereby helping reduce a thickness of the entire rotating shaft mechanism 230, and implementing the lightweight of the electronic device 10.

The surface of the side of the metal base body that faces the flexible circuit board 300 is provided with the insulation lubricating coating, so that a surface of a side of the protection portion 2342 that faces the flexible circuit board 300 forms the insulation wear-resistant surface. The insulation lubricating coating has a small coefficient of friction and good lubrication and wear resistance, so that the surface of the flexible circuit board 300 can be prevented from being worn, and integrity of the flexible circuit board 300 can be protected. In addition, the insulation lubricating coating has good insulation, so that the flexible circuit board 300 can be in insulation contact with the protection portion 2342. During long-term use of the flexible circuit board 300, the flexible circuit board 300 can be prevented from being shorted to the protection portion 2342, thereby preventing a short circuit from occurring to the flexible circuit board 300, and reducing a risk that the flexible circuit board 300 burns out. Further, the reliability of the flexible circuit board 300 can be improved, and the service life of the flexible circuit board 300 can be prolonged.

It may be understood that when the main structure of the protection portion 2342 is the metal material, the protection portion 2342 is separately disposed, so that the protection portion 2342 can be prevented from affecting appearance quality of the support main body 2341. Especially when the support member 234 is used as an appearance member of the electronic device 10, surface processing may be performed on the support main body 2341, so that a texture and a color of an outer surface of the support main body 2341 satisfy requirements on an entire machine. In addition, the protection portion 2342 is formed by separately spraying the insulation lubricating coating on the metal base body. The protection portion 2342 is an independent component, and the protection portion 2342 may be independently processed and manufactured. Therefore, an impact on the appearance quality of the support main body 2341 caused by spraying the insulation lubricating coating can be avoided, a problem such as color cast or speckles on the surface of the support main body 2341 can be avoided, and an appearance of the entire machine can be prevented from being affected.

In some examples, only the surface of the metal base body that faces the flexible circuit board 300 may be covered with the insulation lubricating coating. In this case, a surface of a side of the protection portion 2342 that faces the support main body 2341 is the surface of the metal base body. When the support main body 2341 is a metal member, it is convenient for the protection portion 2342 to be connected to the support main body 2341. For example, the protection portion 2342 and the support main body 2341 may be connected through soldering or adhesion, or the protection portion 2342 may be locked to the support main body 2341 by using a locking member such as a screw or a rivet.

In some other examples, surfaces of two sides of the metal base body may be covered with the insulation lubricating coating. In other words, the insulation lubricating coating covers the entire outer surface of the metal base body. In this way, it is convenient to spray the outer surface of the metal base body with the insulation lubricating coating. In addition, when the metal base body is of a symmetrical structure, because the surfaces of the two sides of the metal base body are covered with the insulation lubricating coating, the metal base body does not need to be positioned, thereby improving mounting efficiency and mounting accuracy of the protection portion 2342.

Refer to FIG. 13. Using the transverse-folding electronic device 10 as an example in the figure, a thickness of the shaft cover 2311 of the electronic device 10 is generally relatively small. In this case, the support member 234 is used as the shaft cover 2311, and when the metal base body is used as a main structure of the protection portion 2342, a part having a smallest thickness of the metal base body is to satisfy a requirement that a thickness ΔH1 is greater than or equal to 0.2 mm, to meet requirements on metal diecasting and forming. If the thickness ΔH1 of the part having the smallest thickness of the metal base body is less than 0.2 mm, the thickness of the part having the smallest thickness of the metal base body is excessively small and does not satisfy the requirements on metal diecasting and forming, and the metal base body may not be manufactured and formed. In addition, even if the metal base body can be formed, the metal base body may not satisfy the reliability requirements due to the excessively small thickness at the part having the smallest thickness.

For example, the thickness ΔH1 of the part having the smallest thickness of the metal base body may be 0.22 mm, 0.24 mm, 0.26 mm, 0.28 mm, 0.30 mm, 0.32 mm, 0.34 mm, 0.36 mm, 0.38 mm, or the like.

The insulation lubricating coating sprayed on the surface of the metal base body may be a high-polymer coating such as a polyimide coating, a polytetrafluoroethylene coating, a polyphenylene sulfide coating, or a polyetheretherketone coating. These high-polymer coatings have low friction damping, are easy to be plastically deformed, adapt to the surface of the metal base body, can enlarge a contact area in contact with the metal base body, and can relieve stress concentration. In addition, these high-polymer coatings have good anti-corrosion and a vibration-absorbing function, which can avoid occurrence of corrosion wear and impact wear. In addition, these high-polymer coatings have good thermal stability, chemical stability, dimensional stability, and other properties, and are stable and reliable.

For a manufacturing process procedure of the protection portion 2342, after the metal base body is provided, the insulation lubricating coating is sprayed on the surface of the metal base body. Then, the metal base body sprayed with the insulation lubricating coating is preheated. For example, the metal base body is placed in a tunnel oven and is baked at a relatively low temperature (for example, in a range of 50°C to 70°C) for a short time (for example, in a range of 4 min to 8 min). Then, the metal base body is hung in the oven and is baked at a relatively high temperature (for example, 200°C to 300°C) for a relatively long time (for example, 50 min to 80 min), to completely solidify the insulation lubricating coating and form the protection portion 2342.

When only a surface of one side of the metal base body is covered with the insulation lubricating coating, before the insulation lubricating coating is sprayed, a surface of the metal base body on which the insulation lubricating coating does not need to be sprayed needs to be covered. After the insulation lubricating coating on the surface of the metal base body is completely solidified, the covering of the metal base body is removed.

In another implementation, the protection portion 2342 may use a plastic material as a main structure. In this case, the protection portion 2342 may include a plastic base body, and the plastic base body may be manufactured by using an injection modeling process. The plastic base body may be adhered to the support main body 2341, or the plastic base body may be locked to the support main body 2341 by using a locking member such as a screw or a rivet.

The plastic base body is used as the main structure of the protection portion 2342, so that a surface of the injection-modeled plastic base body is smooth, a coefficient of friction is small, and wear resistance is good. In addition, the plastic base body can implement insulation, and there is no need to perform surface spraying or other surface processing on the plastic base body, so that production costs of the protection portion 2342 can be saved. In addition, compared with the metal base body, the plastic base body has a smaller weight, and can reduce a weight of the support member 234. Further, a weight of the rotating shaft mechanism 230 is reduced, thereby reducing a weight of the entire electronic device 10.

In some examples, the protection portion 2342 may include only the plastic base body. An outer surface of the plastic base body is smooth and the entire surface is insulated, and the entire outer surface of the plastic base body is equivalent to an insulation wear-resistant surface. In this case, the flexible circuit board 300 is in direct contact with the surface of the plastic base body. In this way, production costs of the protection portion 2342 can be saved.

In some other examples, the surface of the plastic base body may further be covered with an insulation lubricating coating, and the protection portion 2342 includes the plastic base body and the insulation lubricating coating. The insulation lubricating coating may cover only a surface of a side of the plastic base body that faces the flexible circuit board 300, or the insulation lubricating coating covers the entire outer surface of the plastic base body, and the insulation lubricating coating forms the insulation wear-resistant surface. Details are not described herein again. In this way, the coefficient of friction of the protection portion 2342 can be further reduced, the lubrication and the wear resistance of the protection portion 2342 can be enhanced, and the protection portion 2342 can be prevented from wearing the flexible circuit board 300.

Refer to FIG. 13. When the plastic base body is used as the main structure of the protection portion 2342, a part having a smallest thickness of the plastic base body is to satisfy a requirement that a thickness ΔH1 is greater than or equal to 0.3 mm, to satisfy requirements on injection modeling of the plastic base body. If the thickness ΔH1 of the part having the smallest thickness of the plastic base body is less than 0.3 mm, the thickness of the part having the smallest thickness of the plastic base body is excessively small and does not satisfy the requirements on injection modeling, and the plastic base body may not be manufactured and formed. In addition, even if the plastic base body can be formed, the metal base body may not satisfy the reliability requirements due to the excessively small thickness at the part having the smallest thickness.

For example, the thickness ΔH1 of the part having the smallest thickness of the plastic base body may be greater than or equal to 0.4 mm, and ΔH1 may be less than or equal to 0.5 mm. In this way, the plastic base body meets the requirements on injection modeling, and the plastic base body can be injection-modeled, thereby ensuring a relatively good production rate of the plastic base body. In addition, the thickness of the plastic base body is prevented from being excessively large, which prevents a thickness of the rotating shaft mechanism 230 from being excessively large, to meet requirements on a thickness of the entire electronic device 10. For example, the thickness ΔH1 of the part having the smallest thickness of the plastic base body may be 0.42 mm, 0.44 mm, 0.46 mm, 0.48 mm, or the like.

Similar to that the metal base body is used as the main structure of the protection portion 2342, when the surface of the plastic base body is covered with the insulation lubricating coating, the insulation lubricating coating sprayed on the surface of the plastic base body may be a high-polymer coating such as a polyimide coating, a polytetrafluoroethylene coating, a polyphenylene sulfide coating, or a polyetheretherketone coating. These high-polymer coatings have low friction damping, are easy to be plastically deformed, have a large contact area in contact with the plastic base body, and can relieve stress concentration. In addition, these high-polymer coatings have good anti-corrosion, thermal stability, chemical stability, dimensional stability, and other properties, and are stable and reliable. Details are not described herein.

Still refer to FIG. 13. When the flexible circuit board 300 is applied to the inward-folding electronic device, specifically by using the transverse-folding electronic device 10 as an example, to ensure that the flexible circuit board 300 has a sufficient movement space and avoid that parts of the flexible circuit board 300 that run through the two sides of the main shaft 231 in the width direction are stuck, when the electronic device 10 is in the unfolded state, there is to be a sufficient spacing between the two ends of the shaft cover 2311 in the width direction and the connecting plate assembly 232. In this case, the support member 234 is used as the shaft cover 2311, and there is to be a sufficient spacing between an edge part of the protection portion 2342 (located at an edge of the support main body 2341) and the connecting plate assembly 232. In other words, there is to be a sufficient spacing between the contact part b of the support member 234 and the connecting plate assembly 232, so that the flexible circuit board 300 can smoothly move and be deformed with the movement of the rotating shaft mechanism 230, thereby preventing the flexible circuit board 300 from being stuck and worn or broken.

For ease of description, for the transverse-folding electronic device 10, in this embodiment, the spacing between the edge part (the contact part b of the support member 234) of the protection portion 2342 and the connecting plate assembly 232 is defined as a preset spacing ΔH2. To meet movement requirements of the flexible circuit board 300, at the edge part of the protection portion 2342, a spacing between the flexible circuit board 300 and the connecting plate assembly 232 is to be greater than or equal to 0.3 mm, to prevent the flexible circuit board 300 from being stuck and worn or broken. Correspondingly, a difference between the preset spacing ΔH2 and the thickness of the flexible circuit board 300 is to be greater than or equal to 0.3 mm.

Using an example in which the thickness of the flexible circuit board 300 is 0.2 mm, the preset spacing ΔH2 may be greater than or equal to 0.5 mm. For example, the preset spacing ΔH2 may be greater than or equal to 0.5 mm and less than or equal to 1.0 mm. For example, the preset spacing ΔH2 is 0.6 mm, 0.7 mm, 0.8 mm, 0.9 mm, or the like.

FIG. 15 is a partial enlarged structural diagram of a position A in FIG. 13. Refer to FIG. 15. When the flexible circuit board 300 is applied to the inward-folding electronic device, the support member 234 is used as the shaft cover 2311 of the main shaft 231, and a right projection of the protection portion 2342 on the support main body 2341 may be located in a coverage region of the support main body 2341. Using an example in which the protection portion 2342 covers the surface of the side of the support main body 2341 that faces the flexible circuit board 300, a width L1 of the support main body 2341 is to be greater than or equal to a width L2 of the protection portion 2342. In addition, in the width direction of the support member 234, the protection portion 2342 is not to extend out of the support main body 2341.

In this configuration, in the width direction of the shaft cover 2311, the protection portion 2342 is prevented from extending out of the support main body 2341. During movement of the electronic device 10, the protection portion 2342 can be prevented from interfering with the housing assembly 200, thereby ensuring smooth movement of the electronic device 10. In addition, when the electronic device 10 is in the folded state, only the support main body 2341 made of the metal material in the shaft cover 2311 is exposed to the outside, so that the protection portion 2342 is prevented from being exposed outside the support main body 2341, to prevent the protection portion 2342 from affecting an appearance effect of the shaft cover 2311.

The width L2 of the protection portion 2342 may be equal to the width L1 of the support main body 2341. In this case, edges of two sides of the protection portion 2342 in the width direction are flush with edges of two sides of the support main body 2341 in the width direction. Alternatively, the width L2 of the protection portion 2342 may be less than the width L1 of the support main body 2341. In this case, the edges of the two sides of the support main body 2341 in the width direction extend out of the edges of the two sides of the protection portion 2342.

When the width L2 of the protection portion 2342 is less than the width L1 of the support main body 2341, a spacing ΔL between an edge of the protection portion 2342 and a corresponding edge of the support main body 2341 is to be less than or equal to an extreme bending radius R of the flexible circuit board 300. ΔL=(L1-L2)/2. In other words, (L1-L2)/2≤R. In this way, when extreme bending is performed on the flexible circuit board 300, the flexible circuit board 300 cannot be in contact with the support main body 2341. Therefore, when the flexible circuit board 300 is normally bent, it can be ensured that the flexible circuit board 300 is not in contact with the support main body 2341, so that the flexible circuit board 300 is prevented from being worn by the support main body 2341 and the flexible circuit board 300 is prevented from being shorted to the support main body 2341, thereby ensuring the reliability and the service life of the flexible circuit board 300.

Using an example in which the extreme bending radius R of the flexible circuit board 300 is 0.5 mm, the spacing ΔL between the edge of the protection portion 2342 and the corresponding edge of the support main body 2341 is to be less than or equal to 0.5 mm. Using an example in which the extreme bending radius of the flexible circuit board 300 is 0.6 mm, the spacing ΔL between the edge of the protection portion 2342 and the corresponding edge of the support main body 2341 is to be less than or equal to 0.6 mm. This is not specifically limited in embodiments of this application.

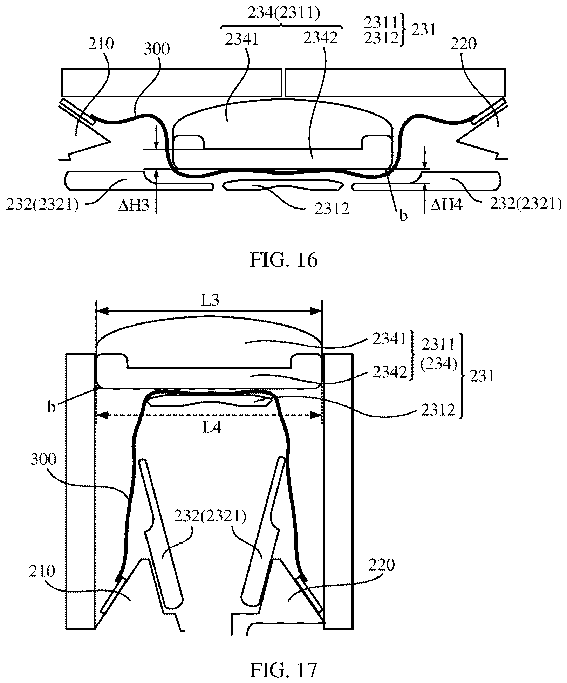

FIG. 16 is a partial structural diagram of another electronic device in an unfolded state according to an embodiment of this application. FIG. 17 is a partial structural diagram of the electronic device in FIG. 16 in a folded state.

Refer to FIG. 16 and FIG. 17. In the figures, the vertical-folding electronic device 10 is used as an example, the main shaft 231 of the rotating shaft mechanism 230 may have a relatively large thickness, and the shaft cover 2311 may also have a relatively large thickness. In this case, the support member 234 is used as the shaft cover 2311, and the thickness of the entire support member 234 may be relatively large. Therefore, the thickness of the protection portion 2342 can be properly designed. Regardless of whether the metal base body is used as the main structure of the protection portion 2342 or whether the plastic base body is used as the main structure of the protection portion 2342, the protection portion 2342 can meet forming requirements. In addition, the thickness of the protection portion 2342 can satisfy the reliability requirements.

Refer to FIG. 16. Similar to the foregoing transverse-folding electronic device 10, in the vertical-folding electronic device 10, when the metal base body is used as the main structure of the protection portion 2342, a part having a smallest thickness of the metal base body is to satisfy that a thickness ΔH3 greater than or equal to 0.2 mm, to satisfy the requirements on metal diecasting and forming. When the plastic base body is used as the main structure of the protection portion 2342, a part having a smallest thickness of the plastic base body is to satisfy a requirement that a thickness ΔH3 is greater than or equal to 0.3 mm, to satisfy requirements on injection modeling of the plastic base body. Details are not described herein.

In addition, when the electronic device 10 is in the unfolded state, there is to be a sufficient spacing between the two ends of the shaft cover 2311 in the width direction and the connecting plate assembly 232. In other words, there is to be a sufficient spacing between the contact part b of the support member 234 and the connecting plate assembly 232, so that the flexible circuit board 300 can smoothly move and be deformed with the movement of the rotating shaft mechanism 230, thereby preventing the flexible circuit board 300 from being stuck and worn or broken.

Refer to 16. For ease of description, for the vertical-folding electronic device 10, in this embodiment, the spacing between the edge part (the contact part b of the support member 234) of the protection portion 2342 and the connecting plate assembly 232 is defined as a preset spacing ΔH4. Similar to the foregoing transverse-folding electronic device 10, a difference between the preset spacing ΔH4 and the thickness of the flexible circuit board 300 may be greater than or equal to 0.3 mm. For example, the preset spacing ΔH4 may be greater than or equal to 0.5 mm and less than or equal to 1.0 mm. Details are not described herein again.

Refer to FIG. 17. Similar to the foregoing transverse-folding electronic device 10, in the vertical-folding electronic device 10, the width L3 of the support main body 2341 is to be greater than or equal to the width L4 of the protection portion 2342. In addition, in the width direction of the support member 234, the protection portion 2342 is not to extend out of the support main body 2341. When the width L4 of the protection portion 2342 is less than the width L3 of the support main body 2341, a spacing ΔL between an edge of the protection portion 2342 and a corresponding edge of the support main body 2341 is to be less than or equal to an extreme bending radius R of the flexible circuit board 300. In other words, (L3-L4)/2≤R. Details are not described herein again.

In the descriptions of embodiments of this application, it should be noted that, unless otherwise explicitly specified or defined, the terms "mount", "connected", and "connection" are to be understood in a broad sense. For example, a connection may be a fixed connection, or may be an indirect connection through an intermediate medium, or may be internal communication between two elements or an interaction relationship between two elements. A person of ordinary skill in the art may understand the specific meanings of the foregoing terms in embodiments of this application according to specific situations.

The terms "first", "second", "third", "fourth", and the like (if existing) in the specification, claims, and the foregoing accompanying drawings in embodiments of this application are used to distinguish similar objects and are not necessarily used to describe a specific order or sequence.

## Claims

1. A rotating shaft mechanism, comprising:
a main shaft; and
a connecting plate assembly, movably connected to two sides of the main shaft in a width direction, wherein
at least one of the main shaft and the connecting plate assembly comprises a support member, and the support member is configured to support a flexible circuit board; and the support member has a contact part, and the contact part is configured to receive a deformation part of the flexible circuit board, wherein
the support member comprises a support main body and a protection portion, the protection portion is connected to a surface of a side of the support main body that faces the flexible circuit board, the protection portion covers at least the contact part, and a surface of a side of the protection portion that faces the flexible circuit board is an insulation wear-resistant surface.

2. The rotating shaft mechanism according to claim 1, wherein the protection portion covers the surface of the side of the support main body that faces the flexible circuit board.

3. The rotating shaft mechanism according to claim 1 or 2, wherein the protection portion comprises a metal base body and an insulation lubricating coating, and the insulation lubricating coating covers at least a surface of a side of the metal base body that faces the flexible circuit board.

4. The rotating shaft mechanism according to claim 3, wherein the insulation lubricating coating covers an outer surface of the metal base body.

5. The rotating shaft mechanism according to claim 3, wherein the insulation lubricating coating comprises one of a polyimide coating, a polytetrafluoroethylene coating, a polyphenylene sulfide coating, and a polyetheretherketone coating.

6. The rotating shaft mechanism according to claim 3, wherein a thickness of a part having a smallest thickness of the metal base body is greater than or equal to 0.2 mm.

7. The rotating shaft mechanism according to claim 1 or 2, wherein the protection portion comprises a plastic base body.

8. The rotating shaft mechanism according to claim 7, wherein a thickness of a part having a smallest thickness of the plastic base body is greater than or equal to 0.3 mm.

9. The rotating shaft mechanism according to claim 7, wherein the protection portion further comprises an insulation lubricating coating, and the insulation lubricating coating covers at least a surface of a side of the plastic base body that faces the flexible circuit board.

10. The rotating shaft mechanism according to claim 9, wherein the insulation lubricating coating covers an outer surface of the plastic base body.

11. The rotating shaft mechanism according to claim 9, wherein the insulation lubricating coating comprises one of a polyimide coating, a polytetrafluoroethylene coating, a polyphenylene sulfide coating, and a polyetheretherketone coating.

12. An electronic device, comprising a first housing, a second housing, a foldable screen, and the rotating shaft mechanism according to any one of claims 1 to 11, wherein the first housing and the second housing are respectively connected to two sides of the rotating shaft mechanism; and
the foldable screen comprises a first non-bendable portion, a bendable portion, and a second non-bendable portion that are sequentially disposed, the first non-bendable portion and the second non-bendable portion are respectively attached to the first housing and the second housing, and the bendable portion is supported by the rotating shaft mechanism.

13. The electronic device according to claim 12, wherein when the electronic device is in a folded state, the first housing and the second housing are relatively stacked, and the foldable screen is located between the first housing and the second housing, wherein
a support member is a shaft cover of the main shaft, and a contact part is two ends of the support member in a width direction.

14. The electronic device according to claim 13, wherein a right projection of the protection portion on the support main body is located in a coverage region of the support main body; and
a spacing between an edge of the protection portion and a corresponding edge of the support main body is less than or equal to an extreme bending radius of the flexible circuit board.

15. The electronic device according to claim 13, wherein when the electronic device is in an unfolded state, a spacing between the contact part of the support member and a connecting plate assembly is a preset spacing, and a difference between the preset spacing and a thickness of the flexible circuit board is greater than or equal to 0.3 mm.

16. The electronic device according to claim 12, wherein when the electronic device is in a folded state, the first housing and the second housing are relatively stacked, and the foldable screen is disposed around outside of the first housing and the second housing, wherein
the support member comprises a first support member, and the first support member is located at the connecting plate assembly.

17. The electronic device according to claim 16, wherein the connecting plate assembly comprises an inner connecting plate and an outer connecting plate that are sequentially connected to a side of the main shaft, the first support member is the inner connecting plate, and the contact part is far away from a first end of the inner connecting plate and close to a second end of the inner connecting plate, wherein
the first end of the inner connecting plate is an end of the inner connecting plate that is close to the main shaft, and the second end of the inner connecting plate is an end of the inner connecting plate that is far away from the main shaft.

18. The electronic device according to claim 16, wherein the rotating shaft mechanism further comprises a decorative plate, the decorative plate is movably connected to the two sides of the main shaft in the width direction, and the decorative plate is located on a side of the main shaft that faces away from the foldable screen.

19. The electronic device according to claim 18, wherein the support member further comprises a second support member, the second support member is the decorative plate, and the contact part is close to a first end of the decorative plate and far away from a second end of the decorative plate, wherein
the first end of the decorative plate is an end of the decorative plate that is close to the main shaft, and the second end of the decorative plate is an end of the decorative plate that is far away from the main shaft.
